# EUROPEAN PATENT SPECIFICATION

(11) **EP 3 898 886 B1**
(45) Date of publication and mention of the grant of the patent: **13.03.2024**
(21) Application number: 20706910.5
(22) Date of filing: 21.01.2020
(51) Int. Cl.: C09K 11/02, C09K 11/88, C09K 11/70, C09K 11/56, H01L 33/50

(54) **THIN SHELL QUANTUM DOTS FOR ENHANCED BLUE LIGHT ABSORPTION**
DÜNNSCHALIGE QUANTENPUNKTE FÜR VERBESSERTE BLAULICHTABSORPTION
POINTS QUANTIQUES À ENVELOPPE MINCE POUR ABSORPTION DE LUMIÈRE BLEUE AMÉLIORÉE

(30) Priority: 24.01.2019 US 201962796278 P
(43) Date of publication of application: 27.10.2021
(73) Proprietor: Shoei Chemical Inc., Tokyo 163-0443 (JP)
(72) Inventor: SUNDERLAND, Christopher, San Jose, California 95136 (US); JEN-LA PLANTE, Ilan, San Jose, California 95110 (US); TU, Alexander, San Jose, California 95132 (US); WANG, Chunming, Milpitas, California 95038 (US); GUO, Wenzhou, San Jose, California 95125 (US)
(74) Representative: Bandpay & Greuter
(86) International application number: PCT/US2020/014470
(87) International publication number: WO 2020/154323

(56) References cited:
- WO-A1-2018/114982
- US-A1- 2017 349 824
- US-A1- 2018 119 007
- US-A1- 2018 331 262

## Description

### BACKGROUND OF THE INVENTION

### Field of the Invention

The invention is in the field of nanostructure synthesis. Provided are highly luminescent nanostructures, particularly highly luminescent quantum dots, comprising a nanocrystal core and at least two thin shell layers. The nanostructures may have additional shell layers. Also provided are methods of preparing the nanostructures, films comprising the nanostructures, and devices comprising the nanostructures.

### Background of the Invention

Tuning the absorbance and emission properties of quantum dots (QDs) for high concentration color conversion applications is critical to their performance. For color conversion applications, efficient absorbance of excitation wavelengths emitted by the blue light emitting diode (LED) backlight is critical to achieving both high photoconversion efficiency (PCE) and high color gamut coverage Moreover, due to the high optical density of the color conversion layer, controlling other quantum dot optical properties including emission wavelength (PWL), emission linewidth (FWHM), Stokes shift, and photoluminescence quantum yield (PLQY) are equally critical to PCE and film emission wavelength.

To exploit the full potential of nanostructures in applications such as films and displays, the nanostructures need to simultaneously meet five criteria: narrow and symmetric emission spectra, high photoluminescence (PL) quantum yields (QYs), high optical stability, eco-friendly materials, and low-cost methods for mass production. Most previous studies on highly emissive and color-tunable quantum dots have concentrated on materials containing cadmium, mercury, or lead. Wang, A., et al., Nanoscale 7:2951-2959 (2015). For example, quantum dots composed of CdSe or CsPbBr₃ are known to possess high per mass absorption coefficients at 450 nm and tunable PWL; however, there are increasing concerns that toxic materials such as cadmium, mercury, or lead would pose serious threats to human health and the environment and the European Union's Restriction of Hazardous Substances rules ban any consumer electronics containing more than trace amounts of these materials. Therefore, there is a need to produce materials that are free of cadmium, mercury, and lead for color conversion applications.

A need exists to prepare nanostructures and nanostructure compositions for use in color conversion applications that have high blue light absorption efficiency, controllable emission wavelength, high photoluminescence quantum yield, and narrow FWHM.

US 2018 119007A discloses luminescent nanostructures, particularly highly luminescent quantum dots, comprising a nanocrystal core and thick shells of ZnSe and ZnS.WO2018114982A1 discloses quantum dots with a core of lll-V material, a first layer of ll-VI material and an external shell of ll-VI material. US2017349824 A1 discloses a nanostructure comprising a nanocrystal core selected from InP, InZnP, InGaP, CdSe, CdS, CdSSe, CdZnSe, CdZnS, ZnSe, ZnSSe, InAs, InGaAs, or InAsP

### BRIEF SUMMARY OF THE INVENTION

The present disclosure provides a nanostructure according to the appended claims.

According to the invention, the nanostructure comprises a first thin shell and a second thin shell, wherein the first thin shell has a thickness of between 0.25 nm and about 0.8 nm and the second shell of the nanostructure has a thickness of between about 0.09 nm and about 0.3 nm.

In some embodiments, the nanostructure exhibits an optical density at 450 nm on a per mass basis of between about 0.30 cm²/mg and about 0.40 cm²/mg.

In some embodiments, the nanostructure exhibits a photoluminescence quantum yield of between about 50% and about 99%.

The nanostructure comprises a first thin shell and a second thin shell, wherein the first thin shell comprises ZnSe and has a thickness between about 0.25 nm and about 0.8 nm, and wherein the second thin shell comprises ZnS and has a thickness between about 0.09 nm and about 0.3 nm.

The present disclosure also provides a method of making the nanostructure according to the appended claims.

In some embodiments, the admixing in (a) further comprises a solvent.

In some embodiments, the solvent is selected from the group consisting of 1-octadecene, 1-hexadecene, 1-eicosene, eicosane, octadecane, hexadecane, tetradecane, squalene, squalane, trioctylphosphine oxide, trioctylamine, trioctylphosphine, dioctyl ether, and combinations thereof.

In some embodiments, the solvent comprises 1-octadecene.

In some embodiments, the admixing in (a) is at a temperature between about 20 °C and about 250 °C.

According to the invention, the nanocrystal core comprises InP.

In some embodiments, the first shell precursor is selected from the group consisting of a cadmium source, a zinc source, an aluminum source, a gallium source, or an indium source.

The first shell precursor comprises a zinc source.

The second shell precursor comprises a selenium source.

The third shell precursor comprises a sulfur source.

In some embodiments, the temperature is raised, lowered, or maintained in (c) to a temperature between about 200 °C and about 310 °C.

In some embodiments, the temperature is raised, lowered, or maintained in (c) to a temperature between about 280 °C and about 310 °C.

In some embodiments, the method of making a nanostructure further comprises isolating the nanostructure.

The present disclosure also provides a nanostructure composition according to the appended claims.

The nanocrystal core in the nanostructure comprises InP.

The first thin shell in the nanostructure has a thickness of between about 0.25 nm and about 0.8 nm.

The second thin shell in the nanostructure has a thickness of between about 0.09 nm and about 0.3 nm.

In some embodiments, the nanostructure in the nanostructure composition exhibits an optical density at 450 nm on a per mass basis of between about 0.30 cm²/mg and about 0.40 cm²/mg.

In some embodiments, the nanostructure in the nanostructure composition exhibits a photoluminescence quantum yield of between about 50% and about 99%.

In some embodiments, the nanostructure in the nanostructure composition comprises a first thin shell and a second thin shell, wherein the first thin shell comprises ZnSe and has a thickness between about 0.25 nm and about 0.8 nm, and wherein the second thin shell comprises ZnS and has a thickness between about 0.09 nm and about 0.3 nm.

In some embodiments, the nanostructure composition comprises between one and five organic resins.

In some embodiments, at least one organic resin in the nanostructure composition is a thermosetting resin or a UV curable resin.

In some embodiments, at least one organic resin in the nanostructure composition is selected from the group consisting of isobornyl acrylate, tetrahydrofurfuryl acrylate, an ethoxylated phenyl acrylate, lauryl acrylate, stearyl acrylate, octyl acrylate, isodecyl acrylate, tridecyl acrylate, caprolactone acrylate, nonyl phenol acrylate, cyclic trimethylolpropane formal acrylate, a methoxy polyethyleneglycol acrylate, a methoxy polypropyleneglycol acrylate, hydroxyethyl acrylate, hydroxypropyl acrylate, and glycidyl acrylate.

In some embodiments, a molded article comprises the nanostructure composition.

In some embodiments, the molded article is a film, a substrate for a display, or a light emitting diode.

In some embodiments, the molded article is a film.

The present disclosure also provides a nanostructure film layer according to the appended claims.

The nanocrystal core in the nanostructure comprises InP.

In some embodiments, the nanostructure in the nanostructure composition comprises a first thin shell and a second thin shell, wherein the first thin shell has a thickness of between about 0.25 nm and about 0.8 nm.

The second thin shell in the nanostructure has a thickness of between about 0.09 nm and about 0.3 nm.

In some embodiments, the nanostructure film layer exhibits a photoconversion efficiency of between about 28% and about 35%.

In some embodiments, the nanostructure film layer exhibits a photoconversion efficiency of between about 28% and about 30%.

In some embodiments, the nanostructure film layer exhibits optical density at 450 nm of between about 0.80 and 0.95.

The nanostructure in the nanostructure film layer comprises a first thin shell and a second thin shell, wherein the first thin shell comprises ZnSe and has a thickness between about 0.25 nm and about 0.8 nm, and wherein the second thin shell comprises ZnS and has a thickness between about 0.09 nm and about 0.3 nm.

In some embodiments, the nanostructure film layer comprises between one and five organic resins.

In some embodiments, the at least one organic resin in the nanostructure film layer is a thermosetting resin or a UV curable resin.

In some embodiments, at least one organic resin in the nanostructure film layer is selected from the group consisting of isobornyl acrylate, tetrahydrofurfuryl acrylate, an ethoxylated phenyl acrylate, lauryl acrylate, stearyl acrylate, octyl acrylate, isodecyl acrylate, tridecyl acrylate, caprolactone acrylate, nonyl phenol acrylate, cyclic trimethylolpropane formal acrylate, a methoxy polyethyleneglycol acrylate, a methoxy polypropyleneglycol acrylate, hydroxyethyl acrylate, hydroxypropyl acrylate, and glycidyl acrylate.

Further, the nanostructure film layer is a color conversion layer in a display device.

### BRIEF DESCRIPTION OF THE DRAWINGS

The accompanying drawings, which are incorporated herein and form a part of the specification, illustrate the present invention and, together with the description, further serve to explain the principles of the invention and to enable a person skilled in the pertinent art to make and use the invention.

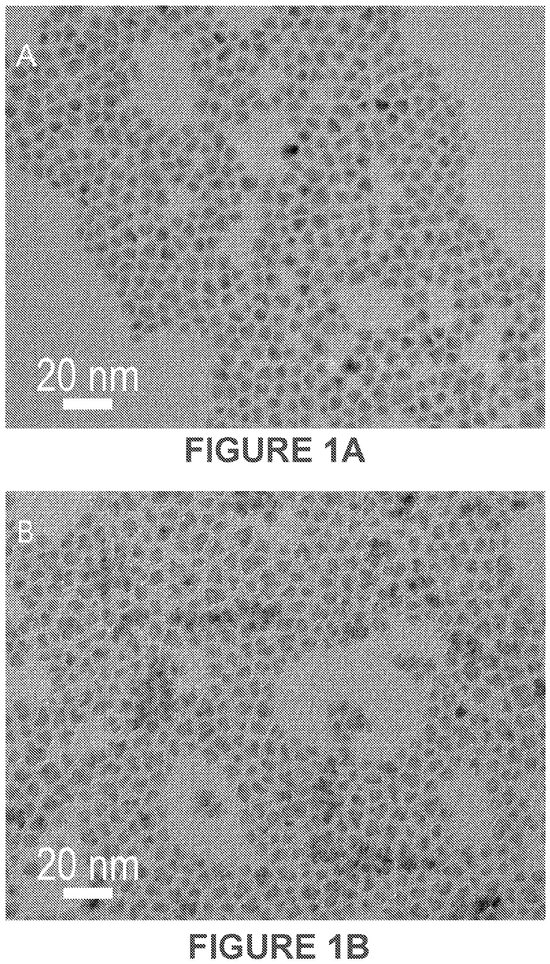

**FIGURE 1A** is a transmission electron microscopy (TEM) image for an InP/ZnSe/ZnS quantum dot prepared using an InP core with an absorbance peak centered at 450 nm and thin shells of ZnSe and ZnS.
**FIGURE 1B** is a TEM image for an InP/ZnSe/ZnS quantum dot prepared using an InP core with an absorbance peak centered at 450 nm and thick shells of ZnSe and ZnS. As shown in FIGURE 1B, thicker shells result in larger particle diameters.

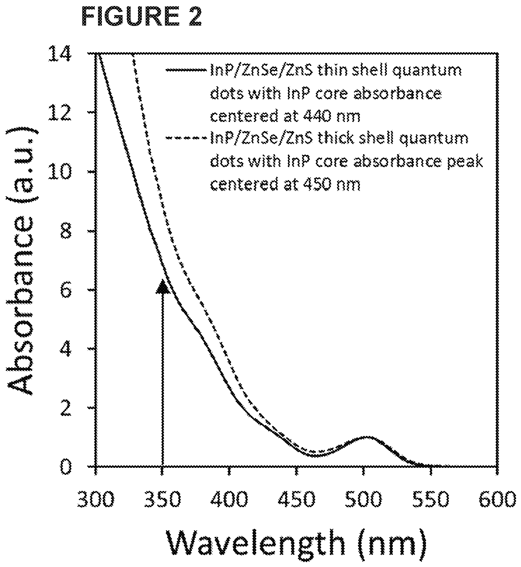

**FIGURE 2** are line graphs showing the absorbance at 350 nm versus the absorbance at the lowest energy excitonic feature (OD₃₅₀/peak) for an InP/ZnSe/ZnS quantum dot prepared using an InP core with an absorbance peak centered at 440 nm having thin shells of ZnSe and ZnS and for an InP/ZnSe/ZnS quantum dot prepared using an InP core with an absorbance peak centered at 450 nm having thick shells of ZnSe and ZnS. As shown in FIGURE 2, thin shell InP/ZnSe/ZnS quantum dots produce OD₃₅₀/peak ratios from 6.0-7.5, whereas thick shell InP/ZnSe/ZnS quantum dots produce OD₃₅₀/peak ratios of greater than 8.0.

### DETAILED DESCRIPTION OF THE INVENTION

Unless defined otherwise, all technical and scientific terms used herein have the same meaning as commonly understood by one of ordinary skill in the art to which the invention pertains. The following definitions supplement those in the art and are directed to the current application and are not to be imputed to any related or unrelated case, e.g., to any commonly owned patent or application. Although any methods and materials similar or equivalent to those described herein can be used in practice for testing, the preferred materials and methods are described herein. Accordingly, the terminology used herein is for the purpose of describing particular embodiments only, and is not intended to be limiting.

As used in this specification and the appended claims, the singular forms "a," "an," and "the" include plural referents unless the context clearly dictates otherwise. Thus, for example, reference to "a nanostructure" includes a plurality of such nanostructures, and the like.

The term "about" as used herein indicates the value of a given quantity varies by ± 10% of the value. For example, "about 100 nm" encompasses a range of sizes from 90 nm to 110 nm, inclusive.

A "nanostructure" is a structure having at least one region or characteristic dimension with a dimension of less than about 500 nm. In some embodiments, the nanostructure has a dimension of less than about 200 nm, less than about 100 nm, less than about 50 nm, less than about 20 nm, or less than about 10 nm. Typically, the region or characteristic dimension will be along the smallest axis of the structure. Examples of such structures include nanowires, nanorods, nanotubes, branched nanostructures, nanotetrapods, tripods, bipods, nanocrystals, nanodots, quantum dots, nanoparticles, and the like. Nanostructures can be, e.g., substantially crystalline, substantially monocrystalline, polycrystalline, amorphous, or a combination thereof. In some embodiments, each of the three dimensions of the nanostructure has a dimension of less than about 500 nm, less than about 200 nm, less than about 100 nm, less than about 50 nm, less than about 20 nm, or less than about 10 nm.

The term "heterostructure" when used with reference to nanostructures refers to nanostructures characterized by at least two different and/or distinguishable material types. Typically, one region of the nanostructure comprises a first material type, while a second region of the nanostructure comprises a second material type. In certain embodiments, the nanostructure comprises a core of a first material and at least one shell of a second (or third etc.) material, where the different material types are distributed radially about the long axis of a nanowire, a long axis of an arm of a branched nanowire, or the center of a nanocrystal, for example. A shell can but need not completely cover the adjacent materials to be considered a shell or for the nanostructure to be considered a heterostructure; for example, a nanocrystal characterized by a core of one material covered with small islands of a second material is a heterostructure. In other embodiments, the different material types are distributed at different locations within the nanostructure; e.g., along the major (long) axis of a nanowire or along a long axis of arm of a branched nanowire. Different regions within a heterostructure can comprise entirely different materials, or the different regions can comprise a base material (e.g., silicon) having different dopants or different concentrations of the same dopant.

As used herein, the "diameter" of a nanostructure refers to the diameter of a cross-section normal to a first axis of the nanostructure, where the first axis has the greatest difference in length with respect to the second and third axes (the second and third axes are the two axes whose lengths most nearly equal each other). The first axis is not necessarily the longest axis of the nanostructure; e.g., for a disk-shaped nanostructure, the cross-section would be a substantially circular cross-section normal to the short longitudinal axis of the disk. Where the cross-section is not circular, the diameter is the average of the major and minor axes of that cross-section. For an elongated or high aspect ratio nanostructure, such as a nanowire, the diameter is measured across a cross-section perpendicular to the longest axis of the nanowire. For a spherical nanostructure, the diameter is measured from one side to the other through the center of the sphere.

The terms "crystalline" or "substantially crystalline," when used with respect to nanostructures, refer to the fact that the nanostructures typically exhibit long-range ordering across one or more dimensions of the structure. It will be understood by one of skill in the art that the term "long range ordering" will depend on the absolute size of the specific nanostructures, as ordering for a single crystal cannot extend beyond the boundaries of the crystal. In this case, "long-range ordering" will mean substantial order across at least the majority of the dimension of the nanostructure. In some instances, a nanostructure can bear an oxide or other coating, or can be comprised of a core and at least one shell. In such instances it will be appreciated that the oxide, shell(s), or other coating can but need not exhibit such ordering (e.g. it can be amorphous, polycrystalline, or otherwise). In such instances, the phrase "crystalline," "substantially crystalline," "substantially monocrystalline," or "monocrystalline" refers to the central core of the nanostructure (excluding the coating layers or shells). The terms "crystalline" or "substantially crystalline" as used herein are intended to also encompass structures comprising various defects, stacking faults, atomic substitutions, and the like, as long as the structure exhibits substantial long range ordering (e.g., order over at least about 80% of the length of at least one axis of the nanostructure or its core). In addition, it will be appreciated that the interface between a core and the outside of a nanostructure or between a core and an adjacent shell or between a shell and a second adjacent shell may contain non-crystalline regions and may even be amorphous. This does not prevent the nanostructure from being crystalline or substantially crystalline as defined herein.

The term "monocrystalline" when used with respect to a nanostructure indicates that the nanostructure is substantially crystalline and comprises substantially a single crystal. When used with respect to a nanostructure heterostructure comprising a core and one or more shells, "monocrystalline" indicates that the core is substantially crystalline and comprises substantially a single crystal.

A "nanocrystal" is a nanostructure that is substantially monocrystalline. A nanocrystal thus has at least one region or characteristic dimension with a dimension of less than about 500 nm. In some embodiments, the nanocrystal has a dimension of less than about 200 nm, less than about 100 nm, less than about 50 nm, less than about 20 nm, or less than about 10 nm. The term "nanocrystal" is intended to encompass substantially monocrystalline nanostructures comprising various defects, stacking faults, atomic substitutions, and the like, as well as substantially monocrystalline nanostructures without such defects, faults, or substitutions. In the case of nanocrystal heterostructures comprising a core and one or more shells, the core of the nanocrystal is typically substantially monocrystalline, but the shell(s) need not be. In some embodiments, each of the three dimensions of the nanocrystal has a dimension of less than about 500 nm, less than about 200 nm, less than about 100 nm, less than about 50 nm, less than about 20 nm, or less than about 10 nm.

The term "quantum dot" (or "dot") refers to a nanocrystal that exhibits quantum confinement or exciton confinement. Quantum dots can be substantially homogenous in material properties, or in certain embodiments, can be heterogeneous, e.g., including a core and at least one shell. The optical properties of quantum dots can be influenced by their particle size, chemical composition, and/or surface composition, and can be determined by suitable optical testing available in the art. The ability to tailor the nanocrystal size, e.g., in the range between about 1 nm and about 15 nm, enables photoemission coverage in the entire optical spectrum to offer great versatility in color rendering.

A "ligand" is a molecule capable of interacting (whether weakly or strongly) with one or more facets of a nanostructure, e.g., through covalent, ionic, van der Waals, or other molecular interactions with the surface of the nanostructure.

"Photoluminescence quantum yield" (PLQY) is the ratio of photons emitted to photons absorbed, e.g., by a nanostructure or population of nanostructures. As known in the art, quantum yield is typically determined by a comparative method using well-characterized standard samples with known quantum yield values.

"Peak emission wavelength" (PWL) is the wavelength where the radiometric emission spectrum of the light source reaches its maximum.

As used herein, the term "shell" refers to material deposited onto the core or onto previously deposited shells of the same or different composition and that result from a single act of deposition of the shell material. The exact shell thickness depends on the material as well as the precursor input and conversion and can be reported in nanometers or monolayers. As used herein, "target shell thickness" refers to the intended shell thickness used for calculation of the required precursor amount. As used herein, "actual shell thickness" refers to the actually deposited amount of shell material after the synthesis and can be measured by methods known in the art. By way of example, actual shell thickness can be measured by comparing particle diameters determined from transmission electron microscopy (TEM) images of nanocrystals before and after a shell synthesis.

As used herein, the term "full width at half-maximum" (FWHM) is a measure of the size distribution of nanoparticles. The emission spectra of nanoparticles generally have the shape of a Gaussian curve. The width of the Gaussian curve is defined as the FWHM and gives an idea of the size distribution of the particles. A smaller FWHM corresponds to a narrower quantum dot nanocrystal size distribution. FWHM is also dependent upon the peak emission wavelength.

As used herein, the term photoconversion effiency (PCE) is a measure of the ratio of green photons emitted (forward cast) versus the total incident blue photons.

### Nanostructure

In some embodiments, the present disclosure provides a nanostructure comprising a nanocrystal core as defined by claim 1.

In some embodiments, the nanostructure is a quantum dot.

### Nanostructure Composition

In some embodiments, the present disclosure provides a nanostructure composition according to claim 7.

### Nanostructure Film Layer

In some embodiments, the present disclosure provides a nanostructure film layer according to claim 11.

In some embodiments, the nanostructure is a quantum dot.

In some embodiments, the nanostructure film layer is a color converson layer.

### Nanostructure Molded Article

In some embodiments, the present disclosure provides a nanostructure molded article comprising:
(a) a first barrier layer;
(b) a second barrier layer; and
(c) a nanostructure layer between the first barrier layer and the second barrier layer, wherein the nanostructure layer is defined by claim 11; and
wherein the nanostructure film layer exhibits a photoconversion efficiency of between about 25% and about 40%.

In some embodiments, the nanostructure is a quantum dot.

In some embodiments, the molded article is a film or substrate for a display. In some embodiments, the molded article is a liquid crystal display. In some embodiments, the molded article is a nanostructure film.

### Nanostructure Core

The nanostructures for use in the present disclosure can be produced from any suitable material, suitably an inorganic material, and more suitably an inorganic conductive or semiconductive material.

The nanostructure comprises a semiconductor core.

Suitable semiconductor core materials, but not all falling under the scope of the invention, include any type of semiconductor, including Group II-VI, Group III-V, Group IV-VI, and Group IV semiconductors. Suitable semiconductor core materials include, but are not limited to, Si, Ge, Sn, Se, Te, B, C (including diamond), P, BN, BP, BAs, AlN, AlP, AlAs, AlSb, GaN, GaP, GaAs, GaSb, InN, InP, InAs, InSb, ZnO, ZnS, ZnSe, ZnTe, CdS, CdSe, CdSeZn, CdTe, HgS, HgSe, HgTe, BeS, BeSe, BeTe, MgS, MgSe, GeS, GeSe, GeTe, SnS, SnSe, SnTe, PbO, PbS, PbSe, PbTe, CuF, CuCl, CuBr, CuI, Si₃N₄, Ge₃N₄, Al₂O₃, AhCO, and combinations thereof.

The synthesis of Group II-VI nanostructures has been described in U.S. Patent Nos. 6,225,198, 6,322,901, 6,207,229, 6,607,829, 7,060,243, 7,374,824, 6,861,155, 7,125,605, 7,566,476, 8,158,193, and 8,101,234 and in U.S. Patent Appl. Publication Nos. 2011/0262752 and 2011/0263062. In some embodiments, the core is a Group II-VI nanocrystal selected from the group consisting of ZnO, ZnSe, ZnS, ZnTe, CdO, CdSe, CdS, CdTe, HgO, HgSe, HgS, and HgTe. In some embodiments, the core is a nanocrystal selected from the group consisting of ZnSe, ZnS, CdSe, or CdS.

Although Group II-VI nanostructures such as CdSe and CdS quantum dots can exhibit desirable luminescence behavior, issues such as the toxicity of cadmium limit the applications for which such nanostructures can be used. Less toxic alternatives with favorable luminescence properties are thus highly desirable. Group III-V nanostructures in general and InP-based nanostructures in particular, offer the best known substitute for cadmium-based materials due to their compatible emission range.

In some embodiments, the nanostructures are free from cadmium. As used herein, the term "free of cadmium" is intended that the nanostructures contain less than 100 ppm by weight of cadmium. The Restriction of Hazardous Substances (RoHS) compliance definition requires that there must be no more than 0.01% (100 ppm) by weight of cadmium in the raw homogeneous precursor materials. The cadmium level in the Cd-free nanostructures of the present invention is limited by the trace metal concentration in the precursor materials. The trace metal (including cadmium) concentration in the precursor materials for the Cd-free nanostructures, can be measured by inductively coupled plasma mass spectroscopy (ICP-MS) analysis, and are on the parts per billion (ppb) level. In some embodiments, nanostructures that are "free of cadmium" contain less than about 50 ppm, less than about 20 ppm, less than about 10 ppm, or less than about 1 ppm of cadmium.

In some embodiments, the core is a Group III-V nanostructure, namely, an InP nanocrystal.

The synthesis of Group III-V nanostructures has been described in U.S. Patent Nos. 5,505,928, 6,306,736, 6,576,291, 6,788,453, 6,821,337, 7,138,098, 7,557,028,
8,062,967, 7,645,397, and 8,282,412 and in U.S. Patent Appl. Publication No. 2015/236195. Synthesis of Group III-V nanostructures has also been described in Wells, R.L., et al., "The use of tris(trimethylsilyl)arsine to prepare gallium arsenide and indium arsenide," Chem. Mater. 1:4-6 (1989) and in Guzelian, A.A., et al., "Colloidal chemical synthesis and characterization of InAs nanocrystal quantum dots," Appl. Phys. Lett. 69: 1432-1434 (1996).

Synthesis of InP-based nanostructures has been described, e.g., in Xie, R., et al., "Colloidal InP nanocrystals as efficient emitters covering blue to near-infrared," *J*. *Am.*

*Chem. Soc. 129*:15432-15433 (2007); Micic, O.I., et al., "Core-shell quantum dots of lattice-matched ZnCdSe2 shells on InP cores: Experiment and theory," J. Phys. Chem. B 104: 12149-12156 (2000); Liu, Z., et al., "Coreduction colloidal synthesis of III-V nanocrystals: The case of InP," Angew. Chem. Int. Ed. Engl. 47:3540-3542 (2008); Li, L. et al., "Economic synthesis of high quality InP nanocrystals using calcium phosphide as the phosphorus precursor," Chem. Mater. 20:2621-2623 (2008); D. Battaglia and X. Peng, "Formation of high quality InP and InAs nanocrystals in a noncoordinating solvent," Nano Letters 2: 1027-1030 (2002); Kim, S., et al., "Highly luminescent InP/GaP/ZnS nanocrystals and their application to white light-emitting diodes," J. Am. Chem. Soc. 134:3804-3809 (2012); Nann, T., et al., "Water splitting by visible light: A nanophotocathode for hydrogen production," Angew. Chem. Int. Ed. 49:1574-1577 (2010); Borchert, H., et al., "Investigation of ZnS passivated InP nanocrystals by XPS," Nano Letters 2:151-154 (2002); L. Li and P. Reiss, "One-pot synthesis of highly luminescent InP/ZnS nanocrystals without precursor injection," J. Am. Chem. Soc. 130:11588-11589 (2008); Hussain, S., et al. "One-pot fabrication of high-quality InP/ZnS (core/shell) quantum dots and their application to cellular imaging," Chemphyschem. 10:1466-1470 (2009); Xu, S., et al., "Rapid synthesis of high-quality InP nanocrystals," J. Am. Chem. Soc. 128:1054-1055 (2006); Micic, O.I., et al., "Size-dependent spectroscopy of InP quantum dots," J. Phys. Chem. B 101:4904-4912 (1997); Haubold, S., et al., "Strongly luminescent InP/ZnS core-shell nanoparticles," Chemphyschem. 5:331-334 (2001); CrosGagneux, A., et al., "Surface chemistry of InP quantum dots: A comprehensive study," J. Am. Chem. Soc. 132:18147-18157 (2010); Micic, O.I., et al., "Synthesis and characterization of InP, GaP, and GalnP2 quantum dots," J. Phys. Chem. 99:7754-7759 (1995); Guzelian, A.A., et al., "Synthesis of size-selected, surface-passivated InP nanocrystals," J. Phys. Chem. 100:7212-7219 (1996); Lucey, D.W., et al., "Monodispersed InP quantum dots prepared by colloidal chemistry in a non-coordinating solvent," Chem. Mater. 17:3754-3762 (2005); Lim, J., et al., "InP@ZnSeS, core@composition gradient shell quantum dots with enhanced stability," Chem. Mater. 23:4459-4463 (2011); and Zan, F., et al., "Experimental studies on blinking behavior of single InP/ZnS quantum dots: Effects of synthetic conditions and UV irradiation," J. Phys. Chem. C 116:394-3950 (2012). However, such efforts have had only limited success in producing InP nanostructures with high quantum yields.

In some embodiments, the core comprises InP.

The synthesis of InP cores having a lowest energy absorbance peak between about 420 nm and about 470 nm have been described in U.S. Patent Appl. Nos. 2010/276638 and 2014/001405.

In some embodiments, the core comprises InP having an absorbance peak between 420 nm and 470 nm. In some embodiments, the core comprises InP having an absorbance peak of about 440 nm. In some embodiments, the core comprises InP having an absorbance peak of about 450 nm.

In some embodiments, the core is doped. In some embodiments, the dopant of the nanocrystal core comprises a metal, including one or more transition metals. In some embodiments, the dopant is a transition metal selected from the group consisting of Ti, Zr, Hf, V, Nb, Ta, Cr, Mo, W, Mn, Tc, Re, Fe, Ru, Os, Co, Rh, Ir, Ni, Pd, Pt, Cu, Ag, Au, and combinations thereof. In some embodiments, the dopant comprises a non-metal. In some embodiments, the dopant is ZnS, ZnSe, ZnTe, CdSe, CdS, CdTe, HgS, HgSe, HgTe, CuInS₂, CuInSe₂, AlN, AlP, AlAs, GaN, GaP, or GaAs.

In some embodiments, the core is purified before deposition of a shell. In some embodiments, the core is filtered to remove precipitate from the core solution.

In some embodiments, the diameter of the core is determined using quantum confinement. Quantum confinement in zero-dimensional nanocrystallites, such as quantum dots, arises from the spatial confinement of electrons within the crystallite boundary. Quantum confinement can be observed once the diameter of the material is of the same magnitude as the de Broglie wavelength of the wave function. The electronic and optical properties of nanoparticles deviate substantially from those of bulk materials. A particle behaves as if it were free when the confining dimension is large compared to the wavelength of the particle. During this state, the bandgap remains at its original energy due to a continuous energy state. However, as the confining dimension decreases and reaches a certain limit, typically in nanoscale, the energy spectrum becomes discrete. As a result, the bandgap becomes size-dependent.

### Thin Shells

In some embodiments, the nanostructures of the present disclosure comprise a core and at least two thin shells. In some embodiments, the at least two thin shells comprise a first thin shell and a second thin shell.

In some embodiments, the first thin shell and the second thin shell comprise different materials. In some embodiments, the core, the first thin shell, and the second thin shell comprise different materials.

In some embodiments, the nanostructures comprise 1, 2, 3, or 4 shell layers.

In some embodiments, the nanostructures comprise 1, 2, or 3 thin shell layers.

In some embodiments, a thin shell has, but not all falling under the scope of the invention, a thickness of between about 0.01 nm and
about 1.5 nm, about 0.01 nm and about 1.0 nm, about 0.01 nm and about 0.8 nm, about 0.01 nm and about 0.35 nm, about 0.01 nm and about 0.3 nm, about 0.01 nm and about 0.25 nm, about 0.01 nm and about 0.2 nm, about 0.01 nm and about 0.1 nm, about 0.01 nm and about 0.05 nm, about 0.01 nm and about 0.03 nm, about 0.03 nm and about 1.5 nm, about 0.03 nm and about 1.0 nm, about 0.03 nm and about 0.8 nm, about 0.03 nm and about 0.35 nm, about 0.03 nm and about 0.3 nm, about 0.03 nm and about 0.25 nm, about 0.03 nm and about 0.2 nm, about 0.03 nm and about 0.1 nm, about 0.03 nm and about 0.05 nm, about 0.05 nm and about 1.5 nm, about 0.05 nm and about 1.0 nm, about 0.05 nm and about 0.8 nm, about 0.05 nm and about 0.35 nm, about 0.05 nm and about 0.3 nm, about 0.05 nm and about 0.25 nm, about 0.05 nm and about 0.2 nm, about 0.05 nm and about 0.1 nm, about 0.1 nm and about 0.35 nm, about 0.1 nm and about 1.0 nm, about 0.1 nm and about 1.5 nm, about 0.1 nm and about 0.8 nm, about 0.1 nm and about 0.3 nm, about 0.1 nm and about 0.25 nm, about 0.1 nm and about 0.2 nm, about 0.2 nm and about 1.5 nm, about 0.2 nm and about 1.0 nm, about 0.2 nm and about 0.8 nm, about 0.2 nm and about 0.35 nm, about 0.2 nm and about 0.3 nm, about 0.2 nm and about 0.25 nm, about 0.25 nm and about 1.5 nm, about 0.25 nm and about 1.0 nm, about 0.25 nm and about 0.8 nm, about 0.25 nm and about 0.35 nm, about 0.25 nm and about 0.3 nm, about 0.3 nm and about 1.5 nm, about 0.3 nm and about 1.0 nm, about 0.3 nm and about 0.8 nm, about 0.3 nm and about 0.35 nm, about 0.35 nm and about 1.5 nm, about 0.35 and about 1.0 nm, about 0.35 nm and about 0.8 nm, about 0.8 nm and about 1.5 nm, about 0.8 nm and about 1.0 nm, or about 1.0 nm and about 1.5 nm.

### First Thin Shell

A first thin shell deposits onto a core that comprises a mixture of Group II and VI elements, namely, a nanocrystal selected from ZnSe.

In some embodiments, but not part of the invention, a first thin shell deposits onto
a core that comprises a mixture of Group III and Group V elements. In some embodiments, a first thin shell deposits onto a core comprising a nanocrystal selected from BN, BP, BAs, BSb, AlN, AlP, AlAs, AlSb, GaN, GaP, GaAs, GaSb, InN, InP, InAs, and InSb. In some embodiments, a first thin shell deposits onto a core comprising InP.

In some embodiments, the first thin shell comprises a mixture of at least two of
zinc, selenium, sulfur, tellurium, and cadmium. In some embodiments, the first thin shell comprises a mixture of two of zinc, selenium, sulfur, tellurium, and cadmium. In some embodiments, the first thin shell comprises a mixture of three of zinc, selenium, sulfur, tellurium, and cadmium. In some embodiments, the first thin shell comprises a mixture of: zinc and sulfur; zinc and selenium; zinc, sulfur, and selenium; zinc and tellurium; zinc, tellurium, and sulfur; zinc, tellurium, and selenium; zinc, cadmium, and sulfur; zinc, cadmium, and selenium; cadmium and sulfur; cadmium and selenium; cadmium, selenium, and sulfur; cadmium and zinc; cadmium, zinc, and sulfur; cadmium, zinc, and selenium; or cadmium, zinc, sulfur, and selenium.

The thickness of the first thin shell can be controlled by varying the amount of precursor provided. For a given thin shell thickness, at least one of the precursors is optionally provided in an amount whereby, when a growth reaction is substantially complete, a thin shell of a predetermined thickness is obtained. If more than one different precursor is provided, either the amount of each precursor can be limited or one of the precursors can be provided in a limiting amount while the others are provided in excess.

In some embodiments, the core comprises a Group II element and the first thin shell comprises a Group VI element. In some embodiments, the Group II element is zinc or cadmium. In some embodiments, the Group VI element is sulfur, selenium, or tellurium. In some embodiments, the molar ratio of the Group II element source and the Group VI element source is between about 0.01:1 and about 1:1.5, about 0.01:1 and about 1:1.25, about 0.01:1 and about 1:1, about 0.01:1 and about 1:0.75, about 0.01:1 and about 1:0.5, about 0.01:1 and about 1:0.25, about 0.01:1 and about 1:0.05, about 0.05:1 and about 1:1.5, about 0.05:1 and about 1:1.25, about 0.05:1 and about 1:1, about 0.05:1 and about 1:0.75, about 0.05:1 and about 1:0.5, about 0.05:1 and about 1:0.25, about 0.25:1 and about 1:1.5, about 0.25:1 and about 1:1.25, about 0.25:1 and about 1:1, about 0.25:1 and about 1:0.75, about 0.25:1 and about 1:0.5, about 0.5:1 and about 1:1.5, about 0.5:1 and about 1:1.25, about 0.5:1 and about 1:1, about 0.5:1 and about 1:0.75, about 0.75:1 and about 1:1.5, about 0.75:1 and about 1:1.25, about 0.75:1 and about 1:1, about 1:1 and about 1:1.5, about 1:1 and about 1:1.25, or about 1:1.25 and about 1:1.5.

In some embodiments, the core comprises a Group III element and the first thin shell comprises a Group VI element. In some embodiments, the Group III element is gallium or indium. In some embodiments, the Group VI element is sulfur, selenium, or tellurium. In some embodiments, the molar ratio of the Group III element source and Group VI element source is between about 0.01:1 and about 1:1.5, about 0.01:1 and about 1:1.25, about 0.01:1 and about 1:1, about 0.01:1 and about 1:0.75, about 0.01:1 and about 1:0.5, about 0.01:1 and about 1:0.25, about 0.01:1 and about 1:0.05, about 0.05:1 and about 1:1.5, about 0.05:1 and about 1:1.25, about 0.05:1 and about 1:1, about 0.05:1 and about 1:0.75, about 0.05:1 and about 1:0.5, about 0.05:1 and about 1:0.25, about 0.25:1 and about 1:1.5, about 0.25:1 and about 1:1.25, about 0.25:1 and about 1:1, about 0.25:1 and about 1:0.75, about 0.25:1 and about 1:0.5, about 0.5:1 and about 1:1.5, about 0.5:1 and about 1:1.25, about 0.5:1 and about 1:1, about 0.5:1 and about 1:0.75, about 0.75:1 and about 1:1.5, about 0.75:1 and about 1:1.25, about 0.75:1 and about 1:1, about 1:1 and about 1:1.5, about 1:1 and about 1:1.25, or about 1:1.25 and about 1:1.5.

In some embodiments, where the core comprises indium and the first thin shell comprises sulfur, the thickness of the first thin shell is controlled by varying the molar ratio of the sulfur source to the indium source. In some embodiments, the molar ratio of the sulfur source to the indium source is between about 0.01:1 and about 1:1.5, about 0.01:1 and about 1:1.25, about 0.01:1 and about 1:1, about 0.01:1 and about 1:0.75, about 0.01:1 and about 1:0.5, about 0.01:1 and about 1:0.25, about 0.01:1 and about 1:0.05, about 0.05:1 and about 1:1.5, about 0.05:1 and about 1:1.25, about 0.05:1 and about 1:1, about 0.05:1 and about 1:0.75, about 0.05:1 and about 1:0.5, about 0.05:1 and about 1:0.25, about 0.25:1 and about 1:1.5, about 0.25:1 and about 1:1.25, about 0.25:1 and about 1:1, about 0.25:1 and about 1:0.75, about 0.25:1 and about 1:0.5, about 0.5:1 and about 1:1.5, about 0.5:1 and about 1:1.25, about 0.5:1 and about 1:1, about 0.5:1 and about 1:0.75, about 0.75:1 and about 1:1.5, about 0.75:1 and about 1:1.25, about 0.75:1 and about 1:1, about 1:1 and about 1:1.5, about 1:1 and about 1:1.25, or about 1:1.25 and about 1:1.5.

In some embodiments, a first thin shell comprises more than one monolayer of shell material. The number of monolayers is an average for all the nanostructures; therefore, the number of monolayers in a first thin shell may be a fraction. In some embodiments, the number of monolayers in a first thin shell is between 0.1 and 3.0, 0.1 and 2.5, 0.1 and 2.0, 0.1 and 1.5, 0.1 and 1.0, 0.1 and 0.5, 0.1 and 0.3, 0.3 and 3.0, 0.3 and 2.5, 0.3 and 2.0, 0.3 and 1.5, 0.3 and 1.0, 0.3 and 0.5, 0.5 and 3.0, 0.5 and 2.5, 0.5 and 2.0, 0.5 and 1.5, 0.5 and 1.0, 1.0 and 3.0, 1.0 and 2.5, 1.0 and 2.0, 1.0 and 1.5, 1.5 and 3.0, 1.5 and 2.5, 1.5 and 2.0, 2.0 and 3.0, 2.0 and 2.5, or 2.5 and 3.0. In some embodiments, the first thin shell comprises between 0.8 and 2.5 monolayers.

The thickness of the first thin shell can be determined using techniques known to those of skill in the art. In some embodiments, the thickness of the thin shell is determined by comparing the average diameter of the nanostructure before and after the addition of the thin shell. In some embodiments, the average diameter of the nanostructure before and after the addition of the thin shell is determined by TEM.

In some embodiments, but not part of the invention, the first thin shell has a thickness of between about 0.01 nm and about 1.5 nm, about 0.01 nm and about 1.0 nm, about 0.01 nm and about 0.8 nm, about 0.01 nm and about 0.35 nm, about 0.01 nm and about 0.3 nm, about 0.01 nm and about 0.25 nm, about 0.01 nm and about 0.2 nm, about 0.01 nm and about 0.1 nm, about 0.01 nm and about 0.05 nm, about 0.01 nm and about 0.03 nm, about 0.03 nm and about 1.5 nm, about 0.03 nm and about 1.0 nm, about 0.03 nm and about 0.8 nm, about 0.03 nm and about 0.35 nm, about 0.03 nm and about 0.3 nm, about 0.03 nm and about 0.25 nm, about 0.03 nm and about 0.2 nm, about 0.03 nm and about 0.1 nm, about 0.03 nm and about 0.05 nm, about 0.05 nm and about 1.5 nm, about 0.05 nm and about 1.0 nm, about 0.05 nm and about 0.8 nm, about 0.05 nm and about 0.35 nm, about 0.05 nm and about 0.3 nm, about 0.05 nm and about 0.25 nm, about 0.05 nm and about 0.2 nm, about 0.05 nm and about 0.1 nm, about 0.1 nm and about 0.35 nm, about 0.1 nm and about 1.0 nm, about 0.1 nm and about 1.5 nm, about 0.1 nm and about 0.8 nm, about 0.1 nm and about 0.3 nm, about 0.1 nm and about 0.25 nm, about 0.1 nm and about 0.2 nm, about 0.2 nm and about 1.5 nm, about 0.2 nm and about 1.0 nm, about 0.2 nm and about 0.8 nm, about 0.2 nm and about 0.35 nm, about 0.2 nm and about 0.3 nm, about 0.2 nm and about 0.25 nm, about 0.25 nm and about 1.5 nm, about 0.25 nm and about 1.0 nm, about 0.25 nm and about 0.8 nm, about 0.25 nm and about 0.35 nm, about 0.25 nm and about 0.3 nm, about 0.3 nm and about 1.5 nm, about 0.3 nm and about 1.0 nm, about 0.3 nm and about 0.8 nm, about 0.3 nm and about 0.35 nm, about 0.35 nm and about 1.5 nm, about 0.35 and about 10 nm, about 0.35 nm and about 0.8 nm, about 0.8 nm and about 1.5 nm, about 0.8 nm and about 1.0 nm, or about 1.0 nm and about 1.5 nm.

In some embodiments, the first thin shell comprises ZnSe shell. A ZnSe monolayer has a thickness of about 0.328 nm.

In some embodiments, where the first thin shell comprises ZnSe, the first thin shell has a thickness of between about 0.01 nm and about 1.0 nm, about 0.01 nm and about 0.8 nm, about 0.01 nm and about 0.35 nm, about 0.01 nm and about 0.3 nm, about 0.01 nm and about 0.25 nm, about 0.01 nm and about 0.2 nm, about 0.01 nm and about 0.1 nm, about 0.01 nm and about 0.05 nm, about 0.05 nm and about 1.0 nm, about 0.05 nm and about 0.8 nm, about 0.05 nm and about 0.35 nm, about 0.05 nm and about 0.3 nm, about 0.05 nm and about 0.25 nm, about 0.05 nm and about 0.2 nm, about 0.05 nm and about 0.1 nm, about 0.1 nm and about 0.35 nm, about 0.1 nm and about 1.0 nm, about 0.1 nm and about 0.8 nm, about 0.1 nm and about 0.3 nm, about 0.1 nm and about 0.25 nm, about 0.1 nm and about 0.2 nm, about 0.2 nm and about 1.0 nm, about 0.2 nm and about 0.8 nm, about 0.2 nm and about 0.35 nm, about 0.2 nm and about 0.3 nm, about 0.2 nm and about 0.25 nm, about 0.25 nm and about 0.35 nm, about 0.25 nm and about 0.3 nm, about 0.3 nm and about 1.0 nm, about 0.3 nm and about 0.8 nm, about 0.3 nm and about 0.35 nm, about 0.35 and about 1.0 nm, about 0.35 nm and about 0.8 nm, or about 0.8 nm and about 1.0 nm. In some embodiments, where the first thin shell comprises ZnSe, the first thin shell has a thickness of between about 0.25 and about 0.8 nm.

In some embodiments, the first thin shell comprises ZnS shell. A ZnS shell monolayer has a thickness of about 0.31 nm.

In some embodiments, where the first thin shell comprises ZnS, the first thin shell has a thickness of between about 0.01 nm and about 10 nm, about 0.01 nm and about 0.8 nm, about 0.01 nm and about 0.35 nm, about 0.01 nm and about 0.3 nm, about 0.01 nm and about 0.25 nm, about 0.01 nm and about 0.2 nm, about 0.01 nm and about 0.1 nm, about 0.01 nm and about 0.05 nm, about 0.05 nm and about 1.0 nm, about 0.05 nm and about 0.8 nm, about 0.05 nm and about 0.35 nm, about 0.05 nm and about 0.3 nm, about 0.05 nm and about 0.25 nm, about 0.05 nm and about 0.2 nm, about 0.05 nm and about 0.1 nm, about 0.1 nm and about 0.35 nm, about 0.1 nm and about 1.0 nm, about 0.1 nm and about 0.8 nm, about 0.1 nm and about 0.3 nm, about 0.1 nm and about 0.25 nm, about 0.1 nm and about 0.2 nm, about 0.2 nm and about 1.0 nm, about 0.2 nm and about 0.8 nm, about 0.2 nm and about 0.35 nm, about 0.2 nm and about 0.3 nm, about 0.2 nm and about 0.25 nm, about 0.25 nm and about 0.35 nm, about 0.25 nm and about 0.3 nm, about 0.3 nm and about 1.0 nm, about 0.3 nm and about 0.8 nm, about 0.3 nm and about 0.35 nm, about 0.35 and about 1.0 nm, about 0.35 nm and about 0.8 nm, or about 0.8 nm and about 1.0 nm. In some embodiments, where the first thin shell comprises ZnS, the first thin shell has a thickness of between about 0.09 and about 0.3 nm.

In some embodiments, the first thin shell comprises ZnS. In some embodiments, the shell precursors used to prepare a ZnS shell comprise a zinc source and a sulfur source.

In some embodiments, the first thin shell comprises ZnSe. In some embodiments, the shell precursors used to prepare a ZnSe shell comprise a zinc source and a selenium source.

In some embodiments, the zinc source is a dialkyl zinc compound. In some embodiments, the zinc source is a zinc carboxylate. In some embodiments, the zinc source is diethylzinc, dimethylzinc, zinc acetate, zinc acetylacetonate, zinc iodide, zinc bromide, zinc chloride, zinc fluoride, zinc carbonate, zinc cyanide, zinc nitrate, zinc oleate, zinc oxide, zinc peroxide, zinc perchlorate, zinc sulfate, zinc hexanoate, zinc octanoate, zinc laurate, zinc myristate, zinc palmitate, zinc stearate, zinc dithiocarbamate, or mixtures thereof. In some embodiments, the zinc source is zinc oleate, zinc hexanoate, zinc octanoate, zinc laurate, zinc myristate, zinc palmitate, zinc stearate, zinc dithiocarbamate, or mixtures thereof. In some embodiments, the zinc source is zinc oleate.

In some embodiments, the sulfur source is selected from elemental sulfur, octanethiol, dodecanethiol, octadecanethiol, tributylphosphine sulfide, cyclohexyl isothiocyanate, α-toluenethiol, ethylene trithiocarbonate, allyl mercaptan, bis(trimethylsilyl) sulfide, trialkylthiourea, trioctylphosphine sulfide, zinc diethyldithiocarbamate, and mixtures thereof. In some embodiments, the sulfur source is an alkyl-substituted zinc dithiocarbamate. In some embodiments, the sulfur source is zinc diethylthiocarbamate. In some embodiments, the sulfur source is dodecanethiol.

In some embodiments, the selenium source is an alkyl-substituted selenourea. In some embodiments, the selenium source is a phosphine selenide. In some embodiments, the selenium source is selected from trioctylphosphine selenide, tri(n-butyl)phosphine selenide, tri(sec-butyl)phosphine selenide, tri(tert-butyl)phosphine selenide, trimethylphosphine selenide, triphenylphosphine selenide, diphenylphosphine selenide, phenylphosphine selenide, tricyclohexylphosphine selenide, cyclohexylphosphine selenide, 1-octaneselenol, 1-dodecaneselenol, selenophenol, elemental selenium, hydrogen selenide, bis(trimethylsilyl) selenide, selenourea, and mixtures thereof. In some embodiments, the selenium source is tri(n-butyl)phosphine selenide, tri(sec-butyl)phosphine selenide, or tri(tert-butyl)phosphine selenide. In some embodiments, the selenium source is trioctylphosphine selenide.

In some embodiments, a first thin shell is synthesized in the presence of at least one nanostructure ligand. Ligands can, e.g., enhance the miscibility of nanostructures in solvents or polymers (allowing the nanostructures to be distributed throughout a composition such that the nanostructures do not aggregate together), increase quantum yield of nanostructures, and/or preserve nanostructure luminescence (e.g., when the nanostructures are incorporated into a matrix). In some embodiments, the ligand(s) for the core synthesis and for the first shell synthesis are the same. In some embodiments, the ligand(s) for the core synthesis and for the first shell synthesis are different. Following synthesis, any ligand on the surface of the nanostructures can be exchanged for a different ligand with other desirable properties. Examples of ligands are disclosed in U.S. Patent Nos. 7,572,395, 8,143,703, 8,425,803, 8,563,133, 8,916,064, 9,005,480, 9,139,770, and 9,169,435, and in U.S. Patent Application Publication No. 2008/0118755.

Ligands suitable for the synthesis of a shell are known by those of skill in the art. In some embodiments, the ligand is a fatty acid selected from the group consisting of lauric acid, caproic acid, myristic acid, palmitic acid, stearic acid, and oleic acid. In some embodiments, the ligand is an organic phosphine or an organic phosphine oxide selected from trioctylphosphine oxide (TOPO), trioctylphosphine (TOP), diphenylphosphine (DPP), triphenylphosphine oxide, and tributylphosphine oxide. In some embodiments, the ligand is an amine selected from the group consisting of dodecylamine, oleylamine, hexadecylamine, dioctylamine, and octadecylamine.

### Second Thin Shell Layer

A second thin shell deposits onto a first thin shell. In some embodiments, a second thin shell deposits onto a first thin shell comprising ZnSe.

The second thin shell comprises a mixture of at least two of zinc and sulfur. In some embodiments, the second thin shell comprises a mixture of two of zinc, selenium, sulfur, tellurium, and cadmium. In some embodiments, the second thin shell comprises a mixture of three of zinc, selenium, sulfur, tellurium, and cadmium. In some embodiments, the second thin shell comprises a mixture of: zinc and sulfur; zinc and selenium; zinc, sulfur, and selenium; zinc and tellurium; zinc, tellurium, and sulfur; zinc, tellurium, and selenium; zinc, cadmium, and sulfur; zinc, cadmium, and selenium; cadmium and sulfur; cadmium and selenium; cadmium, selenium, and sulfur; cadmium and zinc; cadmium, zinc, and sulfur; cadmium, zinc, and selenium; or cadmium, zinc, sulfur, and selenium.

The thickness of the second thin shell can be controlled by varying the amount of precursor provided. For a given second thin shell thickness, at least one of the precursors is optionally provided in an amount whereby, when a growth reaction is substantially complete, a thin shell of a predetermined thickness is obtained. If more than one different precursor is provided, either the amount of each precursor can be limited or one of the precursors can be provided in a limiting amount while the others are provided in excess.

In some embodiments, the core comprises a Group II element and the second thin shell comprises a Group VI element. In some embodiments, the Group II element is zinc or cadmium. In some embodiments, the Group VI element is sulfur, selenium, or tellurium. In some embodiments, the molar ratio of the Group II element source and the Group VI element source is between about 0.01:1 and about 1:1.5, about 0.01:1 and about 1:1.25, about 0.01:1 and about 1:1, about 0.01:1 and about 1:0.75, about 0.01:1 and about 1:0.5, about 0.01:1 and about 1:0.25, about 0.01:1 and about 1:0.05, about 0.05:1 and about 1:1.5, about 0.05:1 and about 1:1.25, about 0.05:1 and about 1:1, about 0.05:1 and about 1:0.75, about 0.05:1 and about 1:0.5, about 0.05:1 and about 1:0.25, about 0.25:1 and about 1:1.5, about 0.25:1 and about 1:1.25, about 0.25:1 and about 1:1, about 0.25:1 and about 1:0.75, about 0.25:1 and about 1:0.5, about 0.5:1 and about 1:1.5, about 0.5:1 and about 1:1.25, about 0.5:1 and about 1:1, about 0.5:1 and about 1:0.75, about 0.75:1 and about 1:1.5, about 0.75:1 and about 1:1.25, about 0.75:1 and about 1:1, about 1:1 and about 1:1.5, about 1:1 and about 1:1.25, or about 1:1.25 and about 1:1.5.

The core comprises a Group III element and the second thin shell comprises a Group VI element. The Group III element is indium. The Group VI element is sulfur. In some embodiments, the molar ratio of the Group III element source and Group VI element source is between about 0.01:1 and about 1:1.5, about 0.01:1 and about 1:1.25, about 0.01:1 and about 1:1, about 0.01:1 and about 1:0.75, about 0.01:1 and about 1:0.5, about 0.01:1 and about 1:0.25, about 0.01:1 and about 1:0.05, about 0.05:1 and about 1:1.5, about 0.05:1 and about 1:1.25, about 0.05:1 and about 1:1, about 0.05:1 and about 1:0.75, about 0.05:1 and about 1:0.5, about 0.05:1 and about 1:0.25, about 0.25:1 and about 1:1.5, about 0.25:1 and about 1:1.25, about 0.25:1 and about 1:1, about 0.25:1 and about 1:0.75, about 0.25:1 and about 1:0.5, about 0.5:1 and about 1:1.5, about 0.5:1 and about 1:1.25, about 0.5:1 and about 1:1, about 0.5:1 and about 1:0.75, about 0.75:1 and about 1:1.5, about 0.75:1 and about 1:1.25, about 0.75:1 and about 1:1, about 1:1 and about 1:1.5, about 1:1 and about 1:1.25, or about 1:1.25 and about 1:1.5.

In some embodiments, where the core comprises indium and the second thin shell comprises sulfur, the thickness of the thin shell is controlled by varying the molar ratio of the sulfur source to the indium source. In some embodiments, the molar ratio of the sulfur source to the indium source is between about 0.01:1 and about 1:1.5, about 0.01:1 and about 1:1.25, about 0.01:1 and about 1:1, about 0.01:1 and about 1:0.75, about 0.01:1 and about 1:0.5, about 0.01:1 and about 1:0.25, about 0.01:1 and about 1:0.05, about 0.05:1 and about 1:1.5, about 0.05:1 and about 1:1.25, about 0.05:1 and about 1:1, about 0.05:1 and about 1:0.75, about 0.05:1 and about 1:0.5, about 0.05:1 and about 1:0.25, about 0.25:1 and about 1:1.5, about 0.25:1 and about 1:1.25, about 0.25:1 and about 1:1, about 0.25:1 and about 1:0.75, about 0.25:1 and about 1:0.5, about 0.5:1 and about 1:1.5, about 0.5:1 and about 1:1.25, about 0.5:1 and about 1:1, about 0.5:1 and about 1:0.75, about 0.75:1 and about 1:1.5, about 0.75:1 and about 1:1.25, about 0.75:1 and about 1:1, about 1:1 and about 1:1.5, about 1:1 and about 1:1.25, or about 1:1.25 and about 1:1.5.

In some embodiments, where the core comprises indium and the second thin shell comprises sulfur, the thickness of the thin shell is controlled by varying the molar ratio of the sulfur source to the indium source. In some embodiments, the molar ratio of the sulfur source to the indium source is between about 0.01:1 and about 1:1.5, about 0.01:1 and about 1:1.25, about 0.01:1 and about 1:1, about 0.01:1 and about 1:0.75, about 0.01:1 and about 1:0.5, about 0.01:1 and about 1:0.25, about 0.01:1 and about 1:0.05, about 0.05:1 and about 1:1.5, about 0.05:1 and about 1:1.25, about 0.05:1 and about 1:1, about 0.05:1 and about 1:0.75, about 0.05:1 and about 1:0.5, about 0.05:1 and about 1:0.25, about 0.25:1 and about 1:1.5, about 0.25:1 and about 1:1.25, about 0.25:1 and about 1:1, about 0.25:1 and about 1:0.75, about 0.25:1 and about 1:0.5, about 0.5:1 and about 1:1.5, about 0.5:1 and about 1:1.25, about 0.5:1 and about 1:1, about 0.5:1 and about 1:0.75, about 0.75:1 and about 1:1.5, about 0.75:1 and about 1:1.25, about 0.75:1 and about 1:1, about 1:1 and about 1:1.5, about 1:1 and about 1:1.25, or about 1:1.25 and about 1:1.5.

The thickness of the second thin shell can be determined using techniques known to those of skill in the art. In some embodiments, the thickness of the second thin shell is determined by comparing the average diameter of the nanostructure before and after the addition of the second thin shell. In some embodiments, the average diameter of the nanostructure before and after the addition of the second thin shell is determined by TEM.

In some embodiments, a second thin shell comprises more than one monolayer of shell material. The number of monolayers is an average for all the nanostructures; therefore, the number of monolayers in a second thin shell may be a fraction. In some embodiments, the number of monolayers in a second thin shell is between 0.1 and 3.0, 0.1 and 2.5, 0.1 and 2.0, 0.1 and 1.5, 0.1 and 1.0, 0.1 and 0.5, 0.1 and 0.3, 0.3 and 3.0, 0.3 and 2.5, 0.3 and 2.0, 0.3 and 1.5, 0.3 and 1.0, 0.3 and 0.5, 0.5 and 3.0, 0.5 and 2.5, 0.5 and 2.0, 0.5 and 1.5, 0.5 and 1.0, 1.0 and 3.0, 1.0 and 2.5, 1.0 and 2.0, 1.0 and 1.5, 1.5 and 3.0, 1.5 and 2.5, 1.5 and 2.0, 2.0 and 3.0, 2.0 and 2.5, or 2.5 and 3.0. In some embodiments, the second thin shell comprises between 0.3 and 1.0 monolayers.

The thickness of the second thin shell can be determined using techniques known to those of skill in the art. In some embodiments, the thickness of the second thin shell is determined by comparing the average diameter of the nanostructure before and after the addition of the thin shell. In some embodiments, the average diameter of the nanostructure before and after the addition of the thin shell is determined by TEM.

In some embodiments, but not part of the inevtnion, the second thin shell has a thickness of between about 0.01 nm and about 1.5 nm, about 0.01 nm and about 1.0 nm, about 0.01 nm and about 0.8 nm, about 0.01 nm and about 0.35 nm, about 0.01 nm and about 0.3 nm, about 0.01 nm and about 0.25 nm, about 0.01 nm and about 0.2 nm, about 0.01 nm and about 0.1 nm, about 0.01 nm and about 0.05 nm, about 0.01 nm and about 0.03 nm, about 0.03 nm and about 1.5 nm, about 0.03 nm and about 1.0 nm, about 0.03 nm and about 0.8 nm, about 0.03 nm and about 0.35 nm, about 0.03 nm and about 0.3 nm, about 0.03 nm and about 0.25 nm, about 0.03 nm and about 0.2 nm, about 0.03 nm and about 0.1 nm, about 0.03 nm and about 0.05 nm, about 0.05 nm and about 1.5 nm, about 0.05 nm and about 1.0 nm, about 0.05 nm and about 0.8 nm, about 0.05 nm and about 0.35 nm, about 0.05 nm and about 0.3 nm, about 0.05 nm and about 0.25 nm, about 0.05 nm and about 0.2 nm, about 0.05 nm and about 0.1 nm, about 0.1 nm and about 0.35 nm, about 0.1 nm and about 1.0 nm, about 0.1 nm and about 1.5 nm, about 0.1 nm and about 0.8 nm, about 0.1 nm and about 0.3 nm, about 0.1 nm and about 0.25 nm, about 0.1 nm and about 0.2 nm, about 0.2 nm and about 1.5 nm, about 0.2 nm and about 1.0 nm, about 0.2 nm and about 0.8 nm, about 0.2 nm and about 0.35 nm, about 0.2 nm and about 0.3 nm, about 0.2 nm and about 0.25 nm, about 0.25 nm and about 1.5 nm, about 0.25 nm and about 1.0 nm, about 0.25 nm and about 0.8 nm, about 0.25 nm and about 0.35 nm, about 0.25 nm and about 0.3 nm, about 0.3 nm and about 1.5 nm, about 0.3 nm and about 1.0 nm, about 0.3 nm and about 0.8 nm, about 0.3 nm and about 0.35 nm, about 0.35 nm and about 1.5 nm, about 0.35 and about 1.0 nm, about 0.35 nm and about 0.8 nm, about 0.8 nm and about 1.5 nm, about 0.8 nm and about 1.0 nm, or about 1.0 nm and about 1.5 nm.

In some embodiments, the second thin shell comprises ZnSe. A ZnSe monolayer has a thickness of about 0.328 nm.

In some embodiments, where the second thin shell comprises ZnSe, the second thin shell has a thickness of between about 0.01 nm and about 1.0 nm, about 0.01 nm and about 0.8 nm, about 0.01 nm and about 0.35 nm, about 0.01 nm and about 0.3 nm, about 0.01 nm and about 0.25 nm, about 0.01 nm and about 0.2 nm, about 0.01 nm and about 0.1 nm, about 0.01 nm and about 0.05 nm, about 0.05 nm and about 1.0 nm, about 0.05 nm and about 0.8 nm, about 0.05 nm and about 0.35 nm, about 0.05 nm and about 0.3 nm, about 0.05 nm and about 0.25 nm, about 0.05 nm and about 0.2 nm, about 0.05 nm and about 0.1 nm, about 0.1 nm and about 0.35 nm, about 0.1 nm and about 1.0 nm, about 0.1 nm and about 0.8 nm, about 0.1 nm and about 0.3 nm, about 0.1 nm and about 0.25 nm, about 0.1 nm and about 0.2 nm, about 0.2 nm and about 1.0 nm, about 0.2 nm and about 0.8 nm, about 0.2 nm and about 0.35 nm, about 0.2 nm and about 0.3 nm, about 0.2 nm and about 0.25 nm, about 0.25 nm and about 0.35 nm, about 0.25 nm and about 0.3 nm, about 0.3 nm and about 1.0 nm, about 0.3 nm and about 0.8 nm, about 0.3 nm and about 0.35 nm, about 0.35 and about 1.0 nm, about 0.35 nm and about 0.8 nm, or about 0.8 nm and about 1.0 nm. In some embodiments, where the second thin shell comprises ZnSe, the second thin shell has a thickness of between about 0.25 and about 0.8 nm.

The second thin shell comprise ZnS shell. A ZnS shell monolayer has a thickness of about 0.31 nm.

In some embodiments, where the second thin shell comprises ZnS, but not falling under the scope of the appended claims, the second thin shell has a thickness of between about 0.01 nm and about 1.0 nm, about 0.01 nm and about 0.8 nm, about 0.01 nm and about 0.35 nm, about 0.01 nm and about 0.3 nm, about 0.01 nm and about 0.25 nm, about 0.01 nm and about 0.2 nm, about 0.01 nm and about 0.1 nm, about 0.01 nm and about 0.05 nm, about 0.05 nm and about 1.0 nm, about 0.05 nm and about 0.8 nm, about 0.05 nm and about 0.35 nm, about 0.05 nm and about 0.3 nm, about 0.05 nm and about 0.25 nm, about 0.05 nm and about 0.2 nm, about 0.05 nm and about 0.1 nm, about 0.1 nm and about 0.35 nm, about 0.1 nm and about 1.0 nm, about 0.1 nm and about 0.8 nm, about 0.1 nm and about 0.3 nm, about 0.1 nm and about 0.25 nm, about 0.1 nm and about 0.2 nm, about 0.2 nm and about 1.0 nm, about 0.2 nm and about 0.8 nm, about 0.2 nm and about 0.35 nm, about 0.2 nm and about 0.3 nm, about 0.2 nm and about 0.25 nm, about 0.25 nm and about 0.35 nm, about 0.25 nm and about 0.3 nm, about 0.3 nm and about 1.0 nm, about 0.3 nm and about 0.8 nm, about 0.3 nm and about 0.35 nm, about 0.35 and about 1.0 nm, about 0.35 nm and about 0.8 nm, or about 0.8 nm and about 1.0 nm. In some embodiments, where the second thin shell comprises ZnS, the second thin shell has a thickness of between about 0.09 and about 0.3 nm.

The second thin shell comprises ZnS shell. In some embodiments, the shell precursors used to prepare a ZnS shell comprise a zinc source and a sulfur source.

In some embodiments, the second thin shell comprises ZnSe shell. In some
embodiments, the shell precursors used to prepare a ZnSe shell comprise a zinc source and a selenium source.

In some embodiments, the zinc source is a dialkyl zinc compound. In some
embodiments, the zinc source is a zinc carboxylate. In some embodiments, the zinc source is diethylzinc, dimethylzinc, zinc acetate, zinc acetylacetonate, zinc iodide, zinc bromide, zinc chloride, zinc fluoride, zinc carbonate, zinc cyanide, zinc nitrate, zinc oleate, zinc oxide, zinc peroxide, zinc perchlorate, zinc sulfate, zinc hexanoate, zinc octanoate, zinc laurate, zinc myristate, zinc palmitate, zinc stearate, zinc dithiocarbamate, or mixtures thereof. In some embodiments, the zinc source is zinc oleate, zinc hexanoate, zinc octanoate, zinc laurate, zinc myristate, zinc palmitate, zinc stearate, zinc dithiocarbamate, or mixtures thereof In some embodiments, the zinc source is zinc oleate.

In some embodiments, the sulfur source is selected from elemental sulfur, octanethiol, dodecanethiol, octadecanethiol, tributylphosphine sulfide, cyclohexyl isothiocyanate, α-toluenethiol, ethylene trithiocarbonate, allyl mercaptan, bis(trimethylsilyl) sulfide, trialkylthiourea, trioctylphosphine sulfide, zinc diethyldithiocarbamate, and mixtures thereof. In some embodiments, the sulfur source is an alkyl-substituted zinc dithiocarbamate. In some embodiments, the sulfur source is zinc diethylthiocarbamate. In some embodiments, the sulfur source is dodecanethiol.

In some embodiments, the selenium source is an alkyl-substituted selenourea. In some embodiments, the selenium source is a phosphine selenide. In some embodiments, the selenium source is selected from trioctylphosphine selenide, tri(n-butyl)phosphine selenide, tri(sec-butyl)phosphine selenide, tri(tert-butyl)phosphine selenide, trimethylphosphine selenide, triphenylphosphine selenide, diphenylphosphine selenide, phenylphosphine selenide, tricyclohexylphosphine selenide, cyclohexylphosphine selenide, 1-octaneselenol, 1-dodecaneselenol, selenophenol, elemental selenium, hydrogen selenide, bis(trimethylsilyl) selenide, selenourea, and mixtures thereof. In some embodiments, the selenium source is tri(n-butyl)phosphine selenide, tri(sec-butyl)phosphine selenide, or tri(tert-butyl)phosphine selenide. In some embodiments, the selenium source is trioctylphosphine selenide.

In some embodiments, a second thin shell is synthesized in the presence of at least one nanostructure ligand. Ligands can, e.g., enhance the miscibility of nanostructures in solvents or polymers (allowing the nanostructures to be distributed throughout a composition such that the nanostructures do not aggregate together), increase quantum yield of nanostructures, and/or preserve nanostructure luminescence (e.g., when the nanostructures are incorporated into a matrix). In some embodiments, the ligand(s) for the core synthesis and for the second shell synthesis are the same. In some embodiments, the ligand(s) for the core synthesis and for the second shell synthesis are different. Following synthesis, any ligand on the surface of the nanostructures can be exchanged for a different ligand with other desirable properties. Examples of ligands are disclosed in U.S. Patent Nos. 7,572,395, 8,143,703, 8,425,803, 8,563,133, 8,916,064, 9,005,480, 9,139,770, and 9,169,435, and in U.S. Patent Application Publication No. 2008/0118755.

Ligands suitable for the synthesis of a shell are known by those of skill in the art. In some embodiments, the ligand is a fatty acid selected from the group consisting of lauric acid, caproic acid, myristic acid, palmitic acid, stearic acid, and oleic acid. In some embodiments, the ligand is an organic phosphine or an organic phosphine oxide selected from trioctylphosphine oxide (TOPO), trioctylphosphine (TOP), diphenylphosphine (DPP), triphenylphosphine oxide, and tributylphosphine oxide. In some embodiments, the ligand is an amine selected from the group consisting of dodecylamine, oleylamine, hexadecylamine, dioctylamine, and octadecylamine.

### Production of a Core with Two Thin Shells

The present disclosure is directed to a method of producing a nanostructure comprising a core and two thin shells according to claim 4.

In some embodiments, the admixing in (a) is in the presence of a solvent. In some embodiments, the solvent is selected from the group consisting of 1-octadecene, 1-hexadecene, 1-eicosene, eicosane, octadecane, hexadecane, tetradecane, squalene, squalane, trioctylphosphine oxide, trioctylamine, trioctylphosphine, and dioctyl ether. In some embodiments, the solvent is 1-octadecene.

In some embodiments, the admixing in (a) is at a temperature between about 20 °C and about 250 °C, about 20 °C and about 200 °C, abuot 20 °C and about 150 °C, about 20 °C and 100 °C, about 20 °C and about 50 °C, about 50 °C and about 250 °C, about 50 °C and 200 °C, about 50 °C and about 150 °C, about 50 °C and about 100 °C, about 100 ° C and about 250 °C, about 100 °C and about 200 °C, about 100 °C and about 150 °C, about 150 °C and 250 °C, about 150 °C and about 200 °C, or about 200 °C and about 250 °C. In some embodiments, the admixing in (a) is at a temperature between about 85 °C and about 200 °C.

In some embodiments, the nanostructure core in (a) comprises a nanocrystal selected from BN, BP, Bas, BSb, AlN, AlP, AlAs, AlSb, GaN, GaP, GaAs, GaSb, InN, InP, InAs, and InSb. In some embodiments, the nanostructure core in (a) comprises InP.

In some embodiments, the first shell precursor in (a) is a Group II precursor, namely, a zinc source.

In some embodiments, the admixing in (a) further comprises at least one nanostructure ligand. Ligands can, e.g., enhance the miscibility of nanostructures in solvents or polymers (allowing the nanostructures to be distributed throughout a composition such that the nanostructures do not aggregate together), increase quantum yield of nanostructures, and/or preserve nanostructure luminescence (e.g., when the nanostructures are incorporated into a matrix). In some embodiments, the ligand(s) for the core synthesis and for the shell synthesis are the same. In some embodiments, the ligand(s) for the core synthesis and for the shell synthesis are different. Following synthesis, any ligand on the surface of the nanostructures can be exchanged for a different ligand with other desirable properties. Examples of ligands are disclosed in U.S. Patent Nos. 7,572,395, 8,143,703, 8,425,803, 8,563,133, 8,916,064, 9,005,480, 9,139,770, and 9,169,435, and in U.S. Patent Application Publication No. 2008/0118755.

In some embodiments, the ligand admixed with the core and the first shell precursor in (a) is a fatty acid selected from the group consisting of lauric acid, caproic acid, myristic acid, palmitic acid, stearic acid, and oleic acid. In some embodiments, the ligand is an organic phosphine or an organic phosphine oxide selected from trioctylphosphine oxide (TOPO), trioctylphosphine (TOP), diphenylphosphine (DPP), triphenylphosphine oxide, and tributylphosphine oxide. In some embodiments, the ligand is an amine selected from the group consisting of dodecylamine, oleylamine, hexadecylamine, dioctylamine, and octadecylamine. In some embodiments, the ligand is lauric acid.

The second shell precursor added in (b) is a Group VI shell precursor, and the second shell precursor is a selenium source. In some embodiments, the selenium source is trioctylphosphine selenide. In some embodiments, the second shell precursor is a sulfur source. In some embodiments, the sulfur source is dodecanethiol.

In some embodiments, after addition of the second precursor in (b), the temperature of the mixture is raised, lowered, or maintained in (c) to a temperature
between about about 50 °C and about 350 °C, about 50 °C and about 300 °C, 50 °C and about 250 °C, about 50 °C and 200 °C, about 50 °C and about 150 °C, about 50 °C and about 100 °C, about 100 °c and about 350 °C, about 100 °C and about 300 °C, about 100 °C and about 250 °C, about 100 °C and about 200 °C, about 100 °C and about 150 °C, about 150 °C and about 350 °C, about 150 °C and about 300 °C, about 150 °C and 250 °C, about 150 °C and about 200 °C, about 200 °C and about 350 °C, about 200 °C and about 300 °C, about 200 °C and about 250 °C, about 250 °C and about 350 °C, about 250 °C and about 300 °C, or about 300 °C and about 350 °C. In some embodiments, the temperature of the mixture in (c) is raised, lowered, or maintained to a temperature between about 200 °C and about 310 °C.

In some embodiments, the temperature in (c) is maintained for between about 2 minutes and about 240 minutes, about 2 minutes and about 200 minutes, about 2 minutes and about 100 minutes, about 2 minutes and about 60 minutes, about 2 minutes and about 40 minutes, about 5 minutes and about 240 minutes, about 5 minutes and about 200 minutes, about 5 minutes and about 100 minutes, about 5 minutes and about 60 minutes, about 5 minutes and about 40 minutes, about 10 minutes and about 240 minutes, about 10 minutes and about 200 minutes, about 10 minutes and about 100 minutes, about 10 minutes and about 60 minutes, about 10 minutes and about 40 minutes, about 40 minutes and about 240 minutes, about 40 minutes and about 200 minutes, about 40 minutes and about 100 minutes, about 40 minutes and about 60 minutes, about 60 minutes and about 240 minutes, about 60 minutes and about 200 minutes, about 60 minutes and about 100 minutes, about 100 minutes and about 240 minutes, about 100 minutes and about 200 minutes, or about 200 minutes and about 240 minutes.

The third shell precursor added in (d) is a Group VI shell precursor, specifically, the third shell precursor is a sulfur source. In some embodiments, the sulfur source is dodecanethiol. In some embodiments, the second shell precursor is a selenium source. In some embodiments, the selenium source is trioctylphosphine selenide.

In some embodiments, the temperature of the admixture in (d) is raised, lowered, or maintained at a temperature between about about 50 °C and about 350 °C, about 50 °C
and about 300 °C, about 50 °C and about 250 °C, about 50 °C and about 200 °C, about 50 °C and about 150 °C, about 50 °C and about 100 °C, about 100 °C and about 350 °C, about 100 °C and about 300 °C, about 100 °C and about 250 °C, about 100 °C and about 200 °C, about 100 °C and about 150 °C, about 150 °C and about 350 °C, about 150 °C and about 300 °C, about 150 °C and about 200 °C, about 200 °C and about 350 °C, about 200 °C and about 300 °C, about 200 °C and about 250 °C, about 250 °C and about 350 °C, about 250 °C and about 300 °C, or about 300 °C and about 350 °C. In some embodiments, the temperature of the mixture is raised, lowered, or maintained in (d) to a temperature between about 250 °C and about 310 °C.

In some embodiments, the temperature is maintained in (d) for a time between about 2 minutes and about 240 minutes, about 2 minutes and about 200 minutes, about 2 minutes and about 100 minutes, about 2 minutes and about 60 minutes, about 2 minutes and about 40 minutes, about 5 minutes and about 240 minutes, about 5 minutes and about 200 minutes, about 5 minutes and about 100 minutes, about 5 minutes and about 60 minutes, about 5 minutes and about 40 minutes, about 10 minutes and about 240 minutes, about 10 minutes and about 200 minutes, about 10 minutes and about 100 minutes, about 10 minutes and about 60 minutes, about 10 minutes and about 40 minutes, about 40 minutes and about 240 minutes, about 40 minutes and about 200 minutes, about 40 minutes and about 100 minutes, about 40 minutes and about 60 minutes, about 60 minutes and about 240 minutes, about 60 minutes and about 200 minutes, about 60 minutes and about 100 minutes, about 100 minutes and about 240 minutes, about 100 minutes and about 200 minutes, or about 200 minutes and about 240 minutes.

In some embodiments, additional shells are produced by further additions of shell precursors that are added to the reaction mixture followed by maintaining at an elevated temperature. Typically, additional shell precursor is provided after reaction of the previous shell is substantially complete (e.g., when at least one of the previous precursors is depleted or removed from the reaction or when no additional growth is detectable). The further additions of precursor create additional shells.

In some embodiments, the nanostructure is cooled before the addition of additional shell precursor to provide further shells. In some embodiments, the nanostructure is maintained at an elevated temperature before the addition of shell precursor to provide further shells.

After sufficient layers of shell have been added for the nanostructure to reach the desired thickness and diameter, the nanostructure can be cooled. In some embodiments, the nanostructures are cooled to room temperature. In some embodiments, an organic solvent is added to dilute the reaction mixture comprising the nanostructures.

In some embodiments, the organic solvent used to dilute the reaction mixture comprising the nanostructures is ethanol, hexane, pentane, toluene, benzene, diethylether, acetone, ethyl acetate, dichloromethane (methylene chloride), chloroform, dimethylformamide, N-methylpyrrolidinone, or combinations thereof. In some embodiments, the organic solvent is toluene.

In some embodiments, nanostructures are isolated. In some embodiments, the nanostructures are isolated by precipitation using an organic solvent. In some embodiments, the nanostructures are isolated by flocculation with ethanol.

The number of shells will determine the size of the nanostructures. The size of the nanostructures can be determined using techniques known to those of skill in the art. In some embodiments, the size of the nanostructures is determined using TEM. In some embodiments, the nanostructures have an average diameter of between 1 nm and 15 nm, between 1 nm and 10 nm, between 1 nm and 9 nm, between 1 nm and 8 nm, between 1 nm and 7 nm, between 1 nm and 6 nm, between 1 nm and 5 nm, between 5 nm and 15 nm, between 5 nm and 10 nm, between 5 nm and 9 nm, between 5 nm and 8 nm, between 5 nm and 7 nm, between 5 nm and 6 nm, between 6 nm and 15 nm, between 6 nm and 10 nm, between 6 nm and 9 nm, between 6 nm and 8 nm, between 6 nm and 7 nm, between 7 nm and 15 nm, between 7 nm and 10 nm, between 7 nm and 9 nm, between 7 nm and 8 nm, between 8 nm and 15 nm, between 8 nm and 10 nm, between 8 nm and 9 nm, between 9 nm and 15 nm, between 9 nm and 10 nm, or between 10 nm and 15 nm. In some embodiments, the nanostructures have an average diameter of between 6 nm and 7 nm.

### Ligand Exchange

In some embodiments, the first ligands in the nanostructures are exchanged with hydrophilic ligands to ensure compatability of the nanostructures with an organic resin. In some embodiments, the first ligand comprises a long alkyl chain. In some embodiments, a first ligand on a nanostructure is exchanged with a low-molecular weight hydrophilic ligand.

In some embodiments, the ligand exchange is performed at a temperature between about 0 °C and about 200 °C, about 0 °C and about 150 °C, about 0 °C and about 100 °C, about 0 °C and about 80 °C, about 20 °C and about 200 °C, about 20 °C and about 150 °C, about 20 °C and about 100 °C, about 20 °C and about 80 °C, about 50 °C and about 200 °C, about 50 °C and about 150 °C, about 50 °C and about 100 °C, about 50 °C and about 80 °C, about 80 °C and about 200 °C, about 80 °C and about 150 °C, about 80 °C and about 100 °C, about 100 °C and about 200 °C, about 100 °C and about 150 °C, or about 150 °C and about 200 °C.

In some embodiments, the ligand exchange is performed over a period of about 1 minute and about 6 hours, about 1 minute and about 2 hours, about 1 minute and about 1 hour, about 1 minute and about 40 minutes, about 1 minute and about 30 minutes, about 1 minute and about 20 minutes, about 1 minute and about 10 minutes, about 10 minutes and about 6 hours, about 10 minutes and about 2 hours, about 10 minutes and about 1 hour, about 10 minutes and about 40 minutes, about 10 minutes and about 30 minutes, about 10 minutes and about 20 minutes, about 20 minutes and about 6 hours, about 20 minutes and about 2 hours, about 20 minutes and about 1 hour, about 20 minutes and about 40 minutes, about 20 minutes and about 30 minutes, about 30 minutes and about 6 hours, about 30 minutes and about 2 hours, about 30 minutes and about 1 hour, about 30 minutes and about 40 minutes, about 40 minutes and about 6 hours, about 40 minutes and about 2 hours, about 40 minutes and about 1 hour, about 1 hour and about 6 hours, about 1 hour and about 2 hours, or about 2 hours and about 6 hours.

In some embodiments, the ligand exchange further comprises a solvent. In some embodiments, the solvent is selected from the group consisting of chloroform, acetone, butanone, ethylene glycol monoethyl ether, ethylene glycol monopropyl ether, 1,4-butanediol diacetate, diethylene glycol monobutyl ether acetate, ethylene glycol monobutyl ether acetate, glyceryl triacetate, heptyl acetate, hexyl acetate, pentyl acetate, butyl acetate, ethyl acetate, diethylene glycol butyl methyl ether, diethyleneglycol monobutyl ether, di(proyplene glyocl) dimethyl ether, diethylene glycol ethyl methyl ether, ethylene glycol monobutyl ether, diethylene glycol diethyl ether, methyl ethyl ketone, methyl isobutyl ketone, monomethyl ether glycol ester, gamma-butyrolactone, methylacetic-3-ethyl ether, butyl carbitol, butyl carbitol acetate, propanediol monomethyl ether, propanediol monomethyl ether acetate, cyclohexane, toluene, xylene, isopropyl alcohol, and combinations thereof.

In some embodiments, the relative content of the organic ligands is monitored and maintained at values of 20-30 weight percent versus the total (inorganic and organic) mass.

The percentage of first ligands displaced by the hydrophilic ligands can be measured by ¹H NMR. In some embodiments, the percentage of first ligands displaced by the hydrophilic ligands is between about 10% and about 100%, about 10% and about 80%, about 10% and about 60%, about 10% and about 40%, about 10% and about 30%, about 10% and about 20%, about 20% and about 100%, about 20% and about 80%, about 20% and about 60%, about 20% and about 40%, about 20% and about 30%, about 30% and about 100%, about 30% and about 80%, about 30% and about 60%, about 30% and about 40%, about 40% and about 100%, about 40% and about 80%, about 40% and about 60%, about 60% and about 100%, about 60% and about 80%, or about 80% and about 100%.

### Nanostructure Properties

The nanostructure is a core/thin shell/thin shell nanostructure. The nanostructure is an InP/ZnSe/ZnS or InP/ZnS/ZnSe nanostructure.

In some embodiments, the nanostructures display a high photoluminescence
quantum yield. In some embodiments, the nanostructures display a photoluminescence quantum yield of between about 50% and about 99%, about 50% and about 95%, about 50% and about 90%, about 50% and about 85%, about 50% and about 80%, about 50% and about 70%, abot 50% and about 60%, 60% and about 99%, about 60% and about 95%, about 60% and about 90%, about 60% and about 85%, about 60% and about 80%, about 60% and about 70%, about 70% and about 99%, about 70% and about 95%, about 70% and about 90%, about 70% and about 85%, about 70% and about 80%, about 80% and about 99%, about 80% and about 95%, about 80% and about 90%, about 80% and about 85%, about 85% and about 99%, about 85% and about 95%, about 80% and about 85%, about 85% and about 99%, about 85% and about 90%, about 90% and about 99%, about 90% and about 95%, or about 95% and about 99%. In some embodiments, the nanostructures display a photoluminescence quantum yield of between about 93% and about 94%.

The photoluminescence spectrum of the nanostructures can cover essentially any
desired portion of the spectrum. In some embodiments, the photoluminescence spectrum for the nanostructures have a emission maximum between 300 nm and 750 nm, 300 nm and 650 nm, 300 nm and 550 nm, 300 nm and 450 nm, 450 nm and 750 nm, 450 nm and 650 nm, 450 nm and 550 nm, 450 nm and 750 nm, 450 nm and 650 nm, 450 nm and 550 nm, 550 nm and 750 nm, 550 nm and 650 nm, or 650 nm and 750 nm. In some embodiments, the photoluminescence spectrum for the nanostructures has an emission maximum of between 450 nm and 550 nm.

The size distribution of the nanostructures can be relatively narrow. In some embodiments, the photoluminescence spectrum of the population of nanostructures can have a full width at half maximum of between 10 nm and 60 nm, 10 nm and 40 nm, 10 nm and 30 nm, 10 nm and 20 nm, 20 nm and 60 nm, 20 nm and 40 nm, 20 nm and 30 nm, 30 nm and 60 nm, 30 nm and 40 nm, or 40 nm and 60 nm. In some embodiments, the photoluminescence spectrum of the population of nanostructures can have a full width at half maximum of between 35 nm and 50 nm.

In some embodiments, the nanostructures emit light having a peak emission wavelength (PWL) between about 400 nm and about 650 nm, about 400 nm and about 600 nm, about 400 nm and about 550 nm, about 400 nm and about 500 nm, about 400 nm and about 450 nm, about 450 nm and about 650 nm, about 450 nm and about 600 nm, about 450 nm and about 550 nm, about 450 nm and about 500 nm, about 500 nm and about 650 nm, about 500 nm and about 600 nm, about 500 nm and about 550 nm, about 550 nm and about 650 nm, about 550 nm and about 600 nm, or about 600 nm and about 650 nm. In some embodiments, the nanostructures emit light having a PWL between about 500 nm and about 550 nm.

As a predictive value for blue light absorption efficiency, the optical density at 450 nm on a per mass basis (OD₄₅₀/mass) can be calculated by measuring the optical density of a nanostructure solution in a 1 cm path length cuvette and dividing by the dry mass per mL of the same solution after removing all volatiles under vacuum (< 200 mTorr) In some embodiments, the nanostructures have an optical density at 450 nm on a per mass basis (OD₄₅₀/mass) of between about 0.28 cm²/mg and about 0.5 cm²/mg, about 0.28 cm²/mg and about 0.4 cm²/mg, about 0.28 cm²/mg and about 0.35 cm²/mg, about 0.28 cm²/mg and about 0.32 cm²/mg, about 0.32 cm²/mg and about 0.5 cm²/mg, about 0.32 cm²/mg and about 0.4 cm²/mg, about 0.32 cm²/mg and about 0.35 cm²/mg, about 0.35 cm²/mg and about 0.5 cm²/mg, about 0.35 cm²/mg and about 0.4 cm²/mg, or about 0.4 cm²/mg and about 0.5 cm²/mg.

### Nanostructure Compositions

The present disclosure provides a nanostructure composition according to claim 7.

In some embodiments, the population of nanostructures emits red, green, or blue light. In some embodiments, the respective portions of red, green, and blue light can be controlled to achieve a desired white point for the white light emitted by a display device incorporating a nanostructure film.

In some embodiments, the nanostructure composition comprises at least one population of nanostructure materials. In some embodiments, the nanostructure composition comprises a population of between 1 and 5, 1 and 4, 1 and 3, 1 and 2, 2 and 5, 2 and 4, 2 and 3, 3 and 5, 3 and 4, or 4 and 5 nanostructures. Any suitable ratio of the populations of nanostructures can be combined to create the desired nanostructure composition characteristics. In some embodiments, the nanostructure is a quantum dot.

The present disclosure provides a method of preparing a nanostructure composition, the method comprising:
(a) providing at least one population of nanostructures, the nanostructures defined by claim 1; and
(b) admixing at least one organic resin with the composition of (a).

In some embodiments, the at least one population of nanostructures is admixed with at least one organic resin at an agitation rate of between about 100 rpm and about 10,000 rpm, about 100 rpm and about 5,000 rpm, about 100 rpm and about 3,000 rpm, about 100 rpm and about 1,000 rpm, about 100 rpm and about 500 rpm, about 500 rpm and about 10,000 rpm, about 500 rpm and about 5,000 rpm, about 500 rpm and about 3,000 rpm, about 500 rpm and about 1,000 rpm, about 1,000 rpm and about 10,000 rpm, about 1,000 rpm and about 5,000 rpm, about 1,000 rpm and about 3,000 rpm, about 3,000 rpm and about 10,000 rpm, about 3,000 rpm and about 10,000 rpm, or about 5,000 rpm and about 10,000 rpm.

In some embodiments, the at least one population of nanostructures is admixed with at least one organic resin for a time of between about 10 minutes and about 24 hours, about 10 minutes and about 20 hours, about 10 minutes and about 15 hours, about 10 minutes and about 10 hours, about 10 minutes and about 5 hours, about 10 minutes and about 1 hour, about 10 minutes and about 30 minutes, about 30 minutes and about 24 hours, about 30 minutes and about 20 hours, about 30 minutes and about 15 hours, about 30 minutes and about 10 hours, about 30 minutes and about 5 hours, about 30 minutes and about 1 hour, about 1 hour and about 24 hours, about 1 hour and about 20 hours, about 1 hour and about 15 hours, about 1 hour and about 10 hours, about 1 hour and about 5 hours, about 5 hours and about 24 hours, about 5 hours and about 20 hours, about 5 hours and about 15 hours, about 5 hours and about 10 hours, about 10 hours and about 24 hours, about 10 hours and about 20 hours, about 10 hours and about 15 hours, about 15 hours and about 24 hours, about 15 hours and about 20 hours, or about 20 hours and about 24 hours.

In some embodiments, the at least one population of nanostructures is admixed with at least one organic resin at a temperature between about -5 °C and about 100 °C, about -5 °C and about 75 °C, about -5 °C and about 50 °C, about -5 °C and about 23 °C, about 23 °C and about 100 °C, about 23 °C and about 75 °C, about 23 °C and about 50 °C, about 50 °C and about 100 °C, about 50 °C and about 75 °C, or about 75 °C and about 100 °C. In some embodiments, the at least one organic resin is admixed with the at least one population of nanostructures at a temperature between about 23 °C and about 50 °C.

In some embodiments, if more than one organic resin is used, the organic resins are added together and mixed. In some embodiments, a first organic resin is mixed with a second organic resin at an agitation rate of between about 100 rpm and about 10,000 rpm, about 100 rpm and about 5,000 rpm, about 100 rpm and about 3,000 rpm, about 100 rpm and about 1,000 rpm, about 100 rpm and about 500 rpm, about 500 rpm and about 10,000 rpm, about 500 rpm and about 5,000 rpm, about 500 rpm and about 3,000 rpm, about 500 rpm and about 1,000 rpm, about 1,000 rpm and about 10,000 rpm, about 1,000 rpm and about 5,000 rpm, about 1,000 rpm and about 3,000 rpm, about 3,000 rpm and about 10,000 rpm, about 3,000 rpm and about 10,000 rpm, or about 5,000 rpm and about 10,000 rpm.

In some embodiments, a first organic resin is mixed with a second organic resin for a time of between about 10 minutes and about 24 hours, about 10 minutes and about 20 hours, about 10 minutes and about 15 hours, about 10 minutes and about 10 hours, about 10 minutes and about 5 hours, about 10 minutes and about 1 hour, about 10 minutes and about 30 minutes, about 30 minutes and about 24 hours, about 30 minutes and about 20 hours, about 30 minutes and about 15 hours, about 30 minutes and about 10 hours, about 30 minutes and about 5 hours, about 30 minutes and about 1 hour, about 1 hour and about 24 hours, about 1 hour and about 20 hours, about 1 hour and about 15 hours, about 1 hour and about 10 hours, about 1 hour and about 5 hours, about 5 hours and about 24 hours, about 5 hours and about 20 hours, about 5 hours and about 15 hours, about 5 hours and about 10 hours, about 10 hours and about 24 hours, about 10 hours and about 20 hours, about 10 hours and about 15 hours, about 15 hours and about 24 hours, about 15 hours and about 20 hours, or about 20 hours and about 24 hours.

### Organic Resin

In some embodiments, the organic resin is a thermosetting resin or a ultraviolet (UV) curable resin. In some embodiments, the organic resin is cured by a method that facilitates roll-to-roll processing.

Thermosetting resins require curing in which they undergo an irreversible molecular cross-linking process which renders the resin infusible. In some embodiments, the thermosetting resin is an epoxy resin, a phenolic resin, a vinyl resin, a melamine resin, a urea resin, an unsaturated polyester resin, a polyurethane resin, an allyl resin, an acrylic resin, a polyamide resin, a polyamide-imide resin, a phenolamine condensation polymerization resin, a urea melamine condensation polymerization resin, or combinations thereof.

In some embodiments, the thermosetting resin is an epoxy resin. Epoxy resins are easily cured without evolution of volatiles or by-products by a wide range of chemicals. Epoxy resins are also compatible with most substrates and tend to wet surfaces easily. See Boyle, M.A., et al., "Epoxy Resins," Composites, Vol. 21, ASM Handbook, pages 78-89 (2001).

In some embodiments, the organic resin is a silicone thermosetting resin. In some embodiments, the silicone thermosetting resin is OE6630A or OE6630B (Dow Corning Corporation, Auburn, MI).

In some embodiments, a thermal initiator is used. In some embodiments, the thermal initiator is AIBN [2,2'-Azobis(2-methylpropionitrile)] or benzoyl peroxide.

UV curable resins are polymers that cure and quickly harden when exposed to a specific light wavelength. In some embodiments, the UV curable resin is a resin having as a functional group a radical-polymerization group such as a (meth)acrylyloxy group, a vinyloxy group, a styryl group, or a vinyl group; a cation-polymerizable group such as an epoxy group, a thioepoxy group, a vinyloxy group, or an oxetanyl group. In some embodiments, the UV curable resin is a polyester resin, a polyether resin, a (meth)acrylic resin, an epoxy resin, a urethane resin, an alkyd resin, a spiroacetal resin, a polybutadiene resin, or a polythiolpolyene resin.

In some embodiments, the UV curable resin is selected from the group consisting of urethane acrylate, allyloxylated cyclohexyl diacrylate, bis(acryloxy ethyl)hydroxyl isocyanurate, bis(acryloxy neopentylglycol)adipate, bisphenol A diacrylate, bisphenol A dimethacrylate, 1,4-butanediol diacrylate, 1,4-butanediol dimethacrylate, 1,3-butyleneglycol diacrylate, 1,3-butyleneglycol dimethacrylate, dicyclopentanyl diacrylate, diethyleneglycol diacrylate, diethyleneglycol dimethacrylate, dipentaerythritol hexaacrylate, dipentaerythritol monohydroxy pentaacrylate, di(trimethylolpropane) tetraacrylate, ethyleneglycol dimethacrylate, glycerol methacrylate, 1,6-hexanediol diacrylate, neopentylglycol dimethacrylate, neopentylglycol hydroxypivalate diacrylate, pentaerythritol triacrylate, pentaerythritol tetraacrylate, phosphoric acid dimethacrylate, polyethyleneglycol diacrylate, polypropyleneglycol diacrylate, tetraethyleneglycol diacrylate, tetrabromobisphenol A diacrylate, triethyleneglycol divinylether, triglycerol diacrylate, trimethylolpropane triacrylate, tripropyleneglycol diacrylate, tris(acryloxyethyl)isocyanurate, phosphoric acid triacrylate, phosphoric acid diacrylate, acrylic acid propargyl ester, vinyl terminated polydimethylsiloxane, vinyl terminated diphenylsiloxane-dimethylsiloxane copolymer, vinyl terminated polyphenylmethylsiloxane, vinyl terminated trifluoromethylsiloxane-dimethylsiloxane copolymer, vinyl terminated diethylsiloxane-dimethylsiloxane copolymer, vinylmethylsiloxane, monomethacryloyloxypropyl terminated polydimethyl siloxane, monovinyl terminated polydimethyl siloxane, monoallyl-mono trimethylsiloxy terminated polyethylene oxide, and combinations thereof.

In some embodiments, the UV curable resin is a mercapto-functional compound that can be cross-linked with an isocyanate, an epoxy, or an unsaturated compound under UV curing conditions. In some embodiments, the polythiol is pentaerythritol tetra(3-mercapto-propionate) (PETMP); trimethylol-propane tri(3-mercapto-propionate) (TMPMP); glycol di(3-mercapto-propionate) (GDMP); tris[25-(3-mercapto-propionyloxy)ethyl]isocyanurate (TEMPIC); di-pentaerythritol hexa(3-mercaptopropionate) (Di-PETMP); ethoxylated trimethylolpropane tri(3-mercapto-propionate) (ETTMP 1300 and ETTMP 700); polycaprolactone tetra(3-mercapto-propionate) (PCL4MP 1350); pentaerythritol tetramercaptoacetate (PETMA); trimethylol-propane trimercaptoacetate (TMPMA); or glycol dimercaptoacetate (GDMA). These compounds are sold under the trade name THIOCURE^{●} by Bruno Bock, Marschacht, Germany.

In some embodiments, the UV curable resin is a polythiol. In some embodiments, the UV curable resin is a polythiol selected from the group consisting of ethylene glycol bis (thioglycolate), ethylene glycol bis(3-mercaptopropionate), trimethylol propane tris (thioglycolate), trimethylol propane tris (3-mercaptopropionate), pentaerythritol tetrakis (thioglycolate), pentaerythritol tetrakis(3-mercaptopropionate) (PETMP), and combinations thereof. In some embodiments, the UV curable resin is PETMP.

In some embodiments, the UV curable resin is a thiol-ene formulation comprising a polythiol and 1,3,5-Triallyl-1,3,5-triazine-2,4,6 (1H,3H,5H)-trione (TTT). In some embodiments, the UV curable resin is a thiol-ene formulation comprising PETMP and TTT.

In some embodiments, the UV curable resin further comprises a photoinitiator. A photoinitiator initiates the crosslinking and/or curing reaction of the photosensitive material during exposure to light. In some embodiments, the photoinitiator is acetophenone-based, benzoin-based, or thioxathenone-based.

In some embodiments, the photoinitiator is a vinyl acrylate-based resin. In some embodments, the photoinitiator is MINS-311RM (Minuta Technology Co., Ltd, Korea).

In some embodiments, the photoinitiator is IRGACURE^{●} 127, IRGACURE* 184, IRGACURE* 184D, IRGACURE* 2022, IRGACURE^{●} 2100, IRGACURE* 250, IRGACURE* 270, IRGACURE^{●} 2959, IRGACURE^{●} 369, IRGACURE^{●} 369 EG, IRGACURE^{●} 379, IRGACURE* 500, IRGACURE* 651, IRGACURE* 754, IRGACURE^{●} 784, IRGACURE^{●} 819, IRGACURE* 819Dw, IRGACURE* 907, IRGACURE^{●} 907 FF, IRGACURE^{●} Oxe01, IRGACURE^{●} TPO-L, IRGACURE^{®} 1173, IRGACURE^{®} 1173D, IRGACURE^{®} 4265, IRGACURE^{®} BP, or IRGACURE^{®} MBF (BASF Corporation, Wyandotte, MI). In some embodiments, the photoinitiator is TPO (2,4,6-trimethylbenzoyl-diphenyl-phosphine oxide) or MBF (methyl benzoylformate).

In some embodiments, the weight percentage of the at least one organic resin in the nanostructure composition is between about 5% and about 99%, about 5% and about 95%, about 5% and about 90%, about 5% and about 80%, about 5% and about 70%, about 5% and about 60%, about 5% and about 50%, about 5% and about 40%, about 5% and about 30%, about 5% and about 20%, about 5% and about 10%, about 10% and about 99%, about 10% and about 95%, about 10% and about 90%, about 10% and about 80%, about 10% and about 70%, about 10% and about 60%, about 10% and about 50%, about 10% and about 40%, about 10% and about 30%, about 10% and about 20%, about 20% and about 99%, about 20% and about 95%, about 20% and about 90%, about 20% and about 80%, about 20% and about 70%, about 20% and about 60%, about 20% and about 50%, about 20% and about 40%, about 20% and about 30%, about 30% and about 99%, about 30% and about 95%, about 30% and about 90%, about 30% and about 80%, about 30% and about 70%, about 30% and about 60%, about 30% and about 50%, about 30% and about 40%, about 40% and about 99%, about 40% and about 95%, about 40% and about 90%, about 40% and about 80%, about 40% and about 70%, about 40% and about 60%, about 40% and about 50%, about 50% and about 99%, about 50% and about 95%, about 50% and about 90%, about 50% and about 80%, about 50% and about 70%, about 50% and about 60%, about 60% and about 99%, about 60% and about 95%, about 60% and about 90%, about 60% and about 80%, about 60% and about 70%, about 70% and about 99%, about 70% and about 95%, about 70% and about 90%, about 70% and about 80%, about 80% and about 99%, about 80% and about 95%, about 80% and about 90%, about 90% and about 99%, about 90% and about 95%, or about 95% and about 99%.

### Nanostructure Layer

The nanostructures used in the present invention can be embedded in a polymeric matrix using any suitable method. As used herein, the term "embedded" is used to indicate that the quantum dot population is enclosed or encased with the polymer that makes up the majority of the component of the matrix. The some embodiments, the at least one nanostructure population is suitably uniformly distributed throughout the matrix. In some embodiments, the at least one nanostructure population is distributed according to an application-specific distribution. In some embodiments, the nanostructures are mixed in a polymer and applied to the surface of a substrate.

In some embodiments, the present disclosure provides a nanostructure film layer defined by claim 11.

In some embodiments, but not falling under the scope of appended claims, the present disclosure provides a nanostructure film layer comprising:
(a) at least one population of nanostructures, the nanostructures comprising a nanocrystal core and at least two thin shells, wherein at least one thin shell has a thickness of between about 0.01 nm and about 1.0 nm, wherein at least one thin shell has a thickness of between about 0.01 nm and about 2.5 nm; and
(b) at least one organic resin;
wherein the nanostructure film layer exhibits a photoconversion efficiency of between about 25% and about 40%.

In some embodiments, the nanostructure film layer is a color conversion layer.

The nanostructure composition can be deposited by any suitable method known in the art, including but not limited to painting, spray coating, solvent spraying, wet coating, adhesive coating, spin coating, tape-coating, roll coating, flow coating, inkjet vapor jetting, drop casting, blade coating, mist deposition, or a combination thereof. Preferably, the quantum dot composition is cured after deposition. Suitable curing methods include photo-curing, such as UV curing, and thermal curing. Traditional laminate film processing methods, tape-coating methods, and/or roll-to-roll fabrication methods can be employed in forming the quantum dot films of the present invention. The quantum dot composition can be coated directly onto the desired layer of a substrate. Alternatively, the quantum dot composition can be formed into a solid layer as an independent element and subsequently applied to the substrate. In some embodiments, the nanostructure composition can be deposited on one or more barrier layers.

### Spin coating

In some embodiments, the nanostructure composition is deposited onto a substrate using spin coating. In spin coating a small amount of material is typically deposited onto the center of a substrate loaded a machine called the spinner which is secured by a vacuum. A high speed of rotation is applied on the substrate through the spinner which causes centripetal force to spread the material from the center to the edge of the substrate. While most of the material would be spun off, a certain amount remains on the substrate, forming a thin film of material on the surface as the rotation continues. The final thickness of the film is determined by the nature of the deposited material and the substrate in addition to the parameters chosen for the spin process such as spin speed, acceleration, and spin time. For typical films, a spin speed of 1500 to 6000 rpm is used with a spin time of 10-60 seconds.

### Mist Deposition

In some embodiments, the nanostructure composition is deposited onto a substrate using mist deposition. Mist deposition takes place at room temperature and atmospheric presuure and allows precise control over film thickness by changing the process conditions. During mist deposition, a liquid source material is turned into a very fine mist and carried to the deposition chamber by nitrogen gas. The mist is then drawn to the wafer surface by a high voltage potential between the field screen and the wafer holder. Once the droplets coalesce on the wafer surface, the wafer is removed from the chamber and thermally cured to allow the solvent to evaporate. The liquid precursor is a mixture of solvent and material to be deposited. It is carried to the atomizer by pressurized nitrogen gas. Price, S.C., et al., "Formation of Ultra-Thin Quantum Dot Films by Mist Deposition," ESC Transactions 77:89-94 (2007).

### Spray coating

In some embodiments, the nanostructure composition is deposited onto a substrate using spray coating. The typical equipment for spray coating comprises a spray nozzle, an atomizer, a precursor solution, and a carrier gas. In the spray deposition process, a precursor solution is pulverized into micro sized drops by means of a carrier gas or by atomization (e.g., ultrasonic, air blast, or electrostatic). The droplets that come out of the atomizer are accelerated by the substrate surface through the nozzle by help of the carrier gas which is controlled and regulated as desired. Relative motion between the spray nozzle and the substrate is defined by design for the purpose of full coverage on the substrate.

In some embodiments, application of the nanostructure composition further comprises a solvent. In some embodiments, the solvent for application of the quantum dot composition is water, organic solvents, inorganic solvents, halogenated organic solvents, or mixtures thereof Illustrative solvents include, but are not limited to, water, D₂O, acetone, ethanol, dioxane, ethyl acetate, methyl ethyl ketone, isopropanol, anisole, γ-butyrolactone, dimethylformamide, N-methylpyrroldinone, dimethylacetamide, hexamethylphosphoramide, toluene, dimethylsulfoxide, cyclopentanone, tetramethylene sulfoxide, xylene, ε-caprolactone, tetrahydrofuran, tetrachloroethylene, chloroform, chlorobenzene, dichloromethane, 1,2-dichloroethane, 1,1,2,2-tetrachloroethane, or mixtures thereof.

In some embodiments, the compositions are thermally cured to form the nanostructure layer. In some embodiments, the compositions are cured using UV light. In some embodiments, the quantum dot composition is coated directly onto a barrier layer of a quantum dot film, and an additional barrier layer is subsequently deposited upon the quantum dot layer to create the quantum dot film. A support substrate can be employed beneath the barrier film for added strength, stability, and coating uniformity, and to prevent material inconsistency, air bubble formation, and wrinkling or folding of the barrier layer material or other materials. Additionally, one or more barrier layers are preferably deposited over a quantum dot layer to seal the material between the top and bottom barrier layers. Suitably, the barrier layers can be deposited as a laminate film and optionally sealed or further processed, followed by incorporation of the nanostructure film into the particular lighting device. The nanostructure composition deposition process can include additional or varied components, as will be understood by persons of ordinary skill in the art. Such embodiments will allow for in-line process adjustments of the nanostructure emission characteristics, such as brightness and color (e.g., to adjust the quantum film white point), as well as the nanostructure film thickness and other characteristics. Additionally, these embodiments will allow for periodic testing of the quantum dot film characteristics during production, as well as any necessary toggling to achieve precise nanostructure film characteristics. Such testing and adjustments can also be accomplished without changing the mechanical configuration of the processing line, as a computer program can be employed to electronically change the respective amounts of mixtures to be used in forming a nanostructure film.

### Nanostructure Film Features and Embodiments

In some embodiments, the nanostructure films of the present invention are used to form display devices. As used herein, a display device refers to any system with a lighting display. Such devices include, but are not limited to, devices encompassing a liquid crystal display (LCD), televisions, computers, mobile phones, smart phones, personal digital assistants (PDAs), gaming devices, electronic reading devices, digital cameras, and the like.

In some embodiments, the optical films containing nanostructure compositions are substantially free of cadmium. As used herein, the term "substantially free of cadmium" is intended that the nanostructure compositions contain less than 100 ppm by weight of cadmium. The RoHS compliance definition requires that there must be no more than 0.01% (100 ppm) by weight of cadmium in the raw homogeneous precursor materials. The cadmium concentration can be measured by inductively coupled plasma mass spectroscopy (ICP-MS) analysis, and are on the parts per billion (ppb) level. In some embodiments, optical films that are "substantially free of cadmium" contain 10 to 90 ppm cadmium. In other embodiment, optical films that are substantially free of cadmium contain less than about 50 ppm, less than about 20 ppm, less than about 10 ppm, or less than about 1 ppm of cadmium.

### Nanostructure Molded Article

In some embodiments, the present disclosure provides a nanostructure molded article comprising:
(a) a first barrier layer;
(b) a second barrier layer; and
(c) a nanostructure layer between the first barrier layer and the second barrier layer, wherein the nanostructure layer comprises a population of nanostructures according to claim 1 and at least one organic resin; and
wherein the nanostructure molded article exhibits a photoconversion efficiency of between about 25% and about 40%.

### Barrier Layers

In some embodiments, the quantum dot molded article comprises one or more barrier layers disposed on either one or both sides of the quantum dot layer. Suitable barrier layers protect the quantum dot layer and the quantum dot molded article from environmental conditions such as high temperatures, oxygen, and moisture. Suitable barrier materials include non-yellowing, transparent optical materials which are hydrophobic, chemically and mechanically compatible with the quantum dot molded article, exhibit photo- and chemical-stability, and can withstand high temperatures. Preferably, the one or more barrier layers are index-matched to the quantum dot molded article. In preferred embodiments, the matrix material of the quantum dot molded article and the one or more adjacent barrier layers are index-matched to have similar refractive indices, such that most of the light transmitting through the barrier layer toward the quantum dot molded article is transmitted from the barrier layer into the quantum dot layer. This index-matching reduces optical losses at the interface between the barrier and matrix materials.

The barrier layers are suitably solid materials, and can be a cured liquid, gel, or polymer. The barrier layers can comprise flexible or non-flexible materials, depending on the particular application. Barrier layers are preferably planar layers, and can include any suitable shape and surface area configuration, depending on the particular lighting application. In preferred embodiments, the one or more barrier layers will be compatible with laminate film processing techniques, whereby the quantum dot layer is disposed on at least a first barrier layer, and at least a second barrier layer is disposed on the quantum dot layer on a side opposite the quantum dot layer to form the quantum dot molded article according to one embodiment of the present invention. Suitable barrier materials include any suitable barrier materials known in the art. For example, suitable barrier materials include glasses, polymers, and oxides. Suitable barrier layer materials include, but are not limited to, polymers such as polyethylene terephthalate (PET); oxides such as silicon oxide, titanium oxide, or aluminum oxide (e.g., SiO₂, Si₂O₃, TiO₂, or Al₂O₃); and suitable combinations thereof. Preferably, each barrier layer of the quantum dot molded article comprises at least 2 layers comprising different materials or compositions, such that the multi-layered barrier eliminates or reduces pinhole defect alignment in the barrier layer, providing an effective barrier to oxygen and moisture penetration into the quantum dot layer. The quantum dot layer can include any suitable material or combination of materials and any suitable number of barrier layers on either or both sides of the quantum dot layer. The materials, thickness, and number of barrier layers will depend on the particular application, and will suitably be chosen to maximize barrier protection and brightness of the quantum dot layer while minimizing thickness of the quantum dot molded article. In preferred embodiments, each barrier layer comprises a laminate film, preferably a dual laminate film, wherein the thickness of each barrier layer is sufficiently thick to eliminate wrinkling in roll-to-roll or laminate manufacturing processes. The number or thickness of the barriers may further depend on legal toxicity guidelines in embodiments where the quantum dots comprise heavy metals or other toxic materials, which guidelines may require more or thicker barrier layers. Additional considerations for the barriers include cost, availability, and mechanical strength.

In some embodiments, the quantum dot film comprises two or more barrier layers adjacent each side of the quantum dot layer, for example, two or three layers on each side or two barrier layers on each side of the quantum dot layer. In some embodiments, each barrier layer comprises a thin glass sheet, e.g., glass sheets having a thickness of about 100 µm, 100 µm or less, or 50 µm or less.

Each barrier layer of the quantum dot film of the present invention can have any suitable thickness, which will depend on the particular requirements and characteristics of the lighting device and application, as well as the individual film components such as the barrier layers and the quantum dot layer, as will be understood by persons of ordinary skill in the art. In some embodiments, each barrier layer can have a thickness of 50 µm or less, 40 µm or less, 30 µm or less, 25 µm or less, 20 µm or less, or 15 µm or less. In certain embodiments, the barrier layer comprises an oxide coating, which can comprise materials such as silicon oxide, titanium oxide, and aluminum oxide (e.g., SiO₂, Si₂O₃, TiO₂, or Al₂O₃). The oxide coating can have a thickness of about 10 µm or less, 5 µm or less, 1 µm or less, or 100 nm or less. In certain embodiments, the barrier comprises a thin oxide coating with a thickness of about 100 nm or less, 10 nm or less, 5 nm or less, or 3 nm or less. The top and/or bottom barrier can consist of the thin oxide coating, or may comprise the thin oxide coating and one or more additional material layers.

### Nanostructure Molded Article Properties

The nanostructure is a core/thin shell/thin shell nanostructure and is an InP/ZnSe/ ZnS or InP/ZnS/ZnSe nanostructure.

In some embodiments, the nanostructure molded article is a nanostructure film.

The photoluminescence spectrum of the nanostructure molded article can cover essentially any desired portion of the spectrum. In some embodiments, the photoluminescence spectrum for the nanostructure molded article has a emission maximum between 300 nm and 750 nm, 300 nm and 650 nm, 300 nm and 550 nm, 300 nm and 450 nm, 450 nm and 750 nm, 450 nm and 650 nm, 450 nm and 550 nm, 450 nm and 750 nm, 450 nm and 650 nm, 450 nm and 550 nm, 550 nm and 750 nm, 550 nm and 650 nm, or 650 nm and 750 nm. In some embodiments, the photoluminescence spectrum for the nanostructure molded article has an emission maximum of between 450 nm and 550 nm.

The size distribution of the nanostructure molded article can be relatively narrow. In some embodiments, the photoluminescence spectrum of the nanostructure molded article has a full width at half maximum of between 10 nm and 60 nm, 10 nm and 40 nm, 10 nm and 30 nm, 10 nm and 20 nm, 20 nm and 60 nm, 20 nm and 40 nm, 20 nm and 30 nm, 30 nm and 60 nm, 30 nm and 40 nm, or 40 nm and 60 nm. In some embodiments, the photoluminescence spectrum of the population of nanostructures can have a full width at half maximum of between 33 nm and 34 nm.

In some embodiments, the nanostructure molded article emits light having a peak emission wavelength (PWL) between about 400 nm and about 650 nm, about 400 nm and about 600 nm, about 400 nm and about 550 nm, about 400 nm and about 500 nm, about 400 nm and about 450 nm, about 450 nm and about 650 nm, about 450 nm and about 600 nm, about 450 nm and about 550 nm, about 450 nm and about 500 nm, about 500 nm and about 650 nm, about 500 nm and about 600 nm, about 500 nm and about 550 nm, about 550 nm and about 650 nm, about 550 nm and about 600 nm, or about 600 nm and about 650 nm. In some embodiments, the nanostructures emit light having a PWL between about 500 nm and about 550 nm.

In some embodiments, the nanostructure molded article displays a high photoconversion efficiency (PCE). In some embodiments, the nanostructure molded article display a PCE of between about 25% and about 40%, about 25% and about 35%, about 25% and about 30%, about 25% and about 28%, about 28% and about 40%, about 28% and about 35%, about 28% and about 30%, about 30% and about 40%, about 30% and about 35%, or about 35% and about 40%. In some embodiments, the nanostructure molded articles display a PCE of between about 28% and about 30%.

In some embodiments, the nanostructure molded article displays an optical density at 450 nm of between about 0.80 and about 0.99, about 0.80 and about 0.95, about 0.80 and about 0.90, about 0.80 and about 0.85, about 0.85 and about 0.99, about 0.85 and about 0.95, about 0.85 and about 0.90, about 0.90 and about 0.99, about 0.90 and about 0.95, or about 0.95 and about 0.99. In some embodiments, the nanostructure molded article displays an optical density at 450 nm of between about 0.80 and about 0.95. In some embodiments, the nanostructure molded article displays an optical density at 450 nm of between about 0.85 and about 0.95.

### Display Device with Nanostructure Color Conversion Layer

In some embodiments, the present invention provides a display device comprising:
(a) a display panel to emit a first light;
(b) a backlight unit configured to provide the first light to the display panel; and
(c) a color filter comprising at least one pixel region comprising a color conversion layer.

In some embodiments, the color filter comprises at least 1, 2, 3, 4, 5, 6, 7, 8, 9, or 10 pixel regions. In some embodiments, when blue light is incident on the color filter, red light, white light, green light, and/or blue light may be respectively emitted through the pixel regions. In some embodiments, the color filter is described in U.S. Patent Appl. Publication No. 2017/153366.

In some embodiments, each pixel region includes a color conversion layer. In some embodiments, a color conversion layer comprises nanostructures described herein configured to convert incident light into light of a first color. In some embodiments, the color conversion layer comprises nanostructures described herein configured to convert incident light into blue light.

In some embodiments, In some embodiments, the display device comprises 1, 2, 3, 4, 5, 6, 7, 8, 9, or 10 color conversion layers. In some embodiments, the display device comprises 1 color conversion layer comprising the nanostructures described herein. In some embodiments, the display device comprises 2 color conversion layers comprising the nanostructures described herein. In some embodiments, the display device comprises 3 color conversion layers comprising the nanostructures described herein. In some embodiments, the display device comprises 4 color conversion layers comprising the nanostructures described herein. In some embodiments, the display device comprises at least one red color conversion layer, at least one green color conversion layer, and at least one blue color conversion layer.

In some embodiments, the color conversion layer has a thickness between about 3 µm and about 10 µm, about 3 µm and about 8 µm, about 3 µm and about 6 µm, about 6 µm and about 10 µm, about 6 µm and about 8 µm, or about 8 µm and about 10 µm. In some embodiments, the color conversion layer has a thickness between about 3 µm and about 10 µm.

The nanostructure color conversion layer can be deposited by any suitable method known in the art, including but not limited to painting, spray coating, solvent spraying, wet coating, adhesive coating, spin coating, tape-coating, roll coating, flow coating, inkjet printing, photoresist patterning, drop casting, blade coating, mist deposition, or a combination thereof. In some embodiments, the nanostructure color conversion layer is deposited by photoresist patterning. In some embodiments, nanostructure color conversion layer is deposited by inkjet printing.

### Inkjet Printing

The formation of thin films using dispersions of nanostructures in organic solvents is often achieved by coating techniques such as spin coating. However, these coating techniques are generally not suitable for the formation of thin films over a large area and do not provide a means to pattern the deposited layer and thus, are of limited use. Inkjet printing allows for precisely patterned placement of thin films on a large scale at low cost. Inkjet printing also allows for precise patterning of quantum dot layers, allows printing pixels of a display, and eliminates photopatterning. Thus, inkjet printing is very attractive for industrial application - particularly in display applications.

Solvents commonly used for inkjet printing are dipropylene glycol monomethyl ether acetate (DPMA), polyglycidyl methacrylate (PGMA), diethylene glycol monoethyl ether acetate (EDGAC), and propylene glycol methyl ether acetate (PGMEA). Volatile solvents are also frequently used in inkjet printing because they allow rapid drying. Volatile solvents include ethanol, methanol, 1-propanol, 2-propanol, acetone, methyl ethyl ketone, methyl isobutyl ketone, ethyl acetate, and tetrahydrofuran. Conventional quantum dots generally cannot be dissolved in these solvents. However, the increased hydrophilicity of the quantum dots comprising poly(alkylene oxide) ligands allows for increased solubility in these solvents.

In some embodiments, the nanostructures described herein used for inkjet printing are dispersed in a solvent selected from DPMA, PGMA, EDGAC, PGMEA, ethanol, methanol, 1-propanol, 2-propanol, acetone, methyl ethyl ketone, methyl isobutyl ketone, ethyl acetate, tetrahydrofuran, chloroform, chlorobenzene, cyclohexane, hexane, heptane, octane, hexadecane, undecane, decane, dodecane, xylene, toluene, benzene, octadecane, tetradecane, butyl ether, or combinations thereof. In some embodiments, the nanostructures comprising a poly(alkylene oxide) ligands described herein used for inkjet printing are dispersed in a solvent selected from DPMA, PGMA, EDGAC, PGMEA, ethanol, methanol, 1-propanol, 2-propanol, acetone, methyl ethyl ketone, methyl isobutyl ketone, ethyl acetate, tetrahydrofuran, or combinations thereof.

In order to be applied by inkjet printing or microdispensing, the inkjet compositions comprising nanostructures should be dissolved in a suitable solvent. The solvent must be able to disperse the nanostructure composition and must not have any detrimental effect on the chosen print head.

In some embodiments, the inkjet composition further comprises one or more additional components such as surface-active compounds, lubricating agents, wetting agents, dispersing agents, hydrophobing agents, adhesive agents, flow improvers, defoaming agents, deaerators, diluents, auxiliaries, colorants, dyes, pigments, sensitizers, stabilizers, and inhibitors.

In some embodiments, the nanostructure compositions described herein comprise by weight of the inkjet composition between about 0.01% and about 20%. In some embodiments, the nanostructures comprising poly(alkylene oxide) ligands comprise by weight of the inkjet composition between about 0.01% and about 20%, about 0.01% and about 15%, about 0.01% and about 10%, about 0.01% and about 5%, about 0.01% and about 2%, about 0.01% and about 1%, about 0.01% and about 0.1%, about 0.01% and about 0.05%, about 0.05% and about 20%, about 0.05% and about 15%, about 0.05% and about 10%, about 0.05% and about 5%, about 0.05% and about 2%, about 0.05% and about 1%, about 0.05% and about 0.1%, about 0.1% and about 20%, about 0.1% and about 15%, about 0.1% and about 10%, about 0.1% and about 5%, about 0.1% and about 2%, about 0.1% and about 1%, about 0.5% and about 20%, about 0.5% and about 15%, about 0.5% and about 10%, about 0.5% and about 5%, about 0.5% and about 2%, about 0.5% and about 1%, about 1% and about 20%, about 1% and about 15%, about 1% and about 10%, about 1% and about 5%, about 1% and about 2%, about 2% and about 20%, about 2% and about 15%, about 2% and about 10%, about 2% and about 5%, about 5% and about 20%, about 5% and about 15%, about 5% and about 10%, about 10% and about 20%, about 10% and about 15%, or about 15% and 20%.

In some embodiments, the inkjet composition comprising a nanostructure or a nanostructure composition described herein is used in the formulation of an electronic device. In some embodiments, the inkjet composition comprising a nanostructure or a nanostructure composition described herein is used in the formulation of an electronic device selected from the group consisting of a nanostructure film, a display device, a lighting device, a backlight unit, a color filter, a surface light-emitting device, an electrode, a magnetic memory device, or a battery. In some embodiments, the inkjet composition comprising a nanostructure composition described herein is used in the formulation of a light-emitting device.

### EXAMPLES

The following examples are illustrative and non-limiting, of the products and methods described herein. Suitable modifications and adaptations of the variety of conditions, formulations, and other parameters normally encountered in the field and which are obvious to those skilled in the art in view of this disclosure are within the scope of the invention.

### Example 1

InP cores were produced through the reaction of an indium carboxylate salt with tris(trimethylsilyl)phosphine. Isolated InP cores were used at concentrations of 10-100 mg/mL in hexane and have absorbance peaks located at 420-470 nm. The synthesis of green InP cores has been disclosed previously in US 2014/0001405 and US 2010/0276638 .

Precursor inputs for ZnSe and ZnS shell growth were calculated based on desired shell thickness, using geometric considerations and assuming uniform, spherical InP core shapes and bulk densities for InP, ZnSe, and ZnS.

Reactions were conducted under air- and water-free conditions using standard Schlenk techniques.

### Example 2

### Thin Shell - 440 nm Core

A known amount of green InP core (10 mg - 3.0 g InP) with absorbance peak centered at 440 nm was added to a reaction mixture containing zinc salts, carboxylic acids, and octadecene as a non-coordinating solvent at temperatures between 85-200 °C. A first ZnSe shell layer was grown immediately thereafter by the injection of sufficient trialkylphosphine selenide (R₃P-Se, wherein R is a trialkyl) to produce 0.5-1.5 monolayers of ZnSe. The solution was then further heated to a temperature between 200-310 °C, and a second ZnSe shell layer was produced by the dropwise addition of sufficient R₃P-Se (wherein R is a trialkyl) to produce an additional 0.3-1.0 monolayers of ZnSe. ZnSe shell growth was monitored by UV-vis spectroscopy on aliquots (50 µL) taken from the reaction flask. Following the completion of the ZnSe shell, a shell of ZnS was produced by the dropwise addition of an alkylthiol sufficient to produce 0.3-1.0 monolayers of ZnS at temperatures between 250-310 °C. Shell growth can also be monitored by the analysis of transmission electron microscope images. Following the completion of all shell layers, the reaction solution was cooled to room temperature, diluted with a hexane/trialkylphosphine mixture and precipitated from solution with ethanol. This isolation procedure can be repeated to decrease the presence of residual organic by-products from the reaction.

The absorbance peak position (abs), emission peak wavelength (PWL), full-width-at-half-maximum (FWHM), photoluminescent quantum yield (PLQY), and ratio of the absorbance at 450 nm versus the absorbance at the peak (OD₄₅₀/peak) were measured on the final material dispersed in hexanes. As a predictive value for blue light absorption efficiency, the optical density at 450 nm on a per mass basis (OD₄₅₀/mass) is calculated by measuring the optical density of a quantum dot solution in a 1 cm path length cuvette and dividing by the dry mass per mL of the same solution after removing all volatiles under vacuum (<200 mTorr).

### Example 3

### Thin Shell - 450 nm Core

A known amount of green InP core (10 mg - 3.0 g InP) with absorbance peak centered at 450 nm was added to a reaction mixture containing zinc salts, carboxylic acids, and octadecene as a non-coordinating solvent at temperatures between 85-200 °C. A first ZnSe shell layer was grown immediately thereafter by the injection of sufficient trialkylphosphine selenide (R₃P-Se, wherein R is a trialkyl) to produce 0.5-1.5 monolayers of ZnSe. The solution was then further heated to a temperature between 200-310 °C, and a second ZnSe shell layer was produced by the dropwise addition of sufficient R₃P-Se (wherein R is trialkyl) to produce an additional 0.3-1.0 monolayers of ZnSe. ZnSe shell growth was monitored by UV-vis spectroscopy on aliquots (50 µL) taken from the reaction flask. Following the completion of the ZnSe shell, a shell of ZnS was produced by the dropwise addition of an alkylthiol sufficient to produce 0.3-1.0 monolayers of ZnS at temperatures between 250-3 10 °C. Shell growth can also be monitored by the analysis of transmission electron microscope images. Following the completion of all shell layers, the reaction solution was cooled to room temperature, diluted with a hexane/trialkylphosphine mixture and precipitated from solution with ethanol. This isolation procedure can be repeated to decrease the presence of residual organic by-products from the reaction.

The absorbance peak position (abs), emission peak wavelength (PWL), full-width-at-half-maximum (FWHM), photoluminescent quantum yield (PLQY), and ratio of the absorbance at 450 nm versus the absorbance at the peak (OD₄₅₀/peak) were measured on the final material dispersed in hexanes. As a predictive value for blue light absorption efficiency, the optical density at 450 nm on a per mass basis (OD₄₅₀/mass) is calculated by measuring the optical density of a quantum dot solution in a 1 cm path length cuvette and dividing by the dry mass per mL of the same solution after removing all volatiles under vacuum (<200 mTorr).

### Comparative Example 4

### Thick Shell - 440 nm Core

A known amount of green InP core (10 mg - 3.0 g InP) with absorbance peak centered at 440 nm was added to a reaction mixture containing zinc salts, carboxylic acids, and octadecene as a non-coordinating solvent at temperatures between 85-200 °C. A first ZnSe shell layer was grown immediately thereafter by the injection of sufficient R₃P-Se (wherein R is a trialkyl) to produce 1.0-2.0 monolayers of ZnSe. The solution was then further heated to a temperature between 200-310 °C, and a second ZnSe shell layer was produced by the dropwise addition of sufficient R₃P-Se (wherein R is a trialkyl) to produce an additional 1.0-2.0 monolayers of ZnSe. Following the completion of the ZnSe shell, a shell of ZnS was produced by the dropwise addition of an alkylthiol sufficient to produce 1.0-3.0 monolayers of ZnS at temperatures between 250-310 °C. Following the completion of all shell layers, the reaction solution was cooled to room temperature, diluted with a hexane/trialkylphosphine mixture and precipitated from solution with ethanol. This example does not fall under the scope of appended claims.

### Comparative Example 5

### Thick Shell - 450 nm Core

A known amount of green InP core (10 mg - 3.0 g InP) with absorbance peak centered at 450 nm was added to a reaction mixture containing zinc salts, carboxylic acids, and octadecene as a non-coordinating solvent at temperatures between 85-200 °C. A first ZnSe shell layer was grown immediately thereafter by the injection of sufficient R₃P-Se (wherein R is a trialkyl) to produce 1.0-2.0 monolayers of ZnSe. The solution was then further heated to a temperature between 200-310 °C, and a second ZnSe shell layer was produced by the dropwise addition of sufficient R₃P-Se (wherein R is a trialkyl) to produce an additional 1.0-2.0 monolayers of ZnSe. Following the completion of the ZnSe shell, a shell of ZnS was produced by the dropwise addition of an alkylthiol sufficient to produce 1.0-3.0 monolayers of ZnS at temperatures between 250-310 °C. Following the completion of all shell layers, the reaction solution was cooled to room temperature, diluted with a hexane/trialkylphosphine mixture and precipitated from solution with ethanol. This example does not fall under the scope of appended claims.

### Example 6

### Comparison of Quantum Dot Structures Prepared with Thin and Thick Shells

The optical properties of InP/ZnSe/ZnS quantum dots with thin shell layers and thick shell layers are compared in TABLE 1.

**TABLE 1**

| Quantum Dots | Core size (nm) | Shell type | Abs (nm) | PWL (nm) | FWHM (nm) | PLQY (%) | OD₄₅₀/peak | OD₄₅₀/mass (cm²/mg) |
|---|---|---|---|---|---|---|---|---|
| Thin Shell - 440 nm Core | 440 | Thin | 502 | 525 | 35 | 93 | 0.59 | 0.33 |
| Thick Shell - 440 nm Core | 440 | Thick | 497 | 522 | 36 | 92 | 0.65 | 0.21 |
| Thin Shell - 450 nm Core | 450 | Thin | 506 | 529 | 37 | 94 | 0.69 | 0.32 |
| Thick Shell - 450 nm Core | 450 | Thick | 502 | 526 | 38 | 92 | 0.73 | 0.24 |

The quantum dot materials prepared with thin shells layers (Examples 2 and 3) combine high blue absorption efficiencies with PWL < 530 nm and FWHM < 38 nm resulting in superior performance in color conversion films.

The shell structure can be characterized by the ratio of the absorbance at 350 nm versus the absorbance at the lowest energy excitonic feature (OD₃₅₀/peak) As shown in FIGURE 2, thin shell InP/ZnSe/ZnS quantum dots showed a OD₃₅₀/peak ratio of 6.0-7.5, whereas thicker shells grown on InP cores with a similar core size showed a OD₃₅₀/peak ratio of > 8.0.

### Example 7

### Film Casting and Measurements

Core/shell quantum dots as prepared in the above examples were ligand exchanged by replacing native hydrophobic fatty acid ligands with low-molecular weight hydrophilic polymers to ensure compatibility with a polymeric resin matrix. For all samples, the relative content of organic ligands was monitored and maintained at values of 20-30 wt% versus the total inorganic plus organic mass. Quantum dot loading in the formulation was controlled on a weight percent basis and is held constant across all demonstrated film samples. Film samples of varying thickness were cast by spin coating the quantum dot/polymer resin formulation and cured using standard methods.

The optical density of a cast quantum dot film was measured by detecting the overall transmittance of blue photons from a blue light emitting diode (LED) centered at 450 nm. Photo conversion efficiency (PCE) is measured as the ratio of green photons emitted (forward cast) versus total incident blue photons. The emission wavelength and full width at half-maximum of the films were measured by recording the emission spectrum of the quantum dot film.

### Example 8

### Comparison of Films Prepared with Quantum Dots with Thin and Thick Shells

The optical properties of films prepared with InP/ZnSe/ZnS quantum dots with thin shell layers and thick shell layers are compared in TABLE 2.

**TABLE 2**

| Quantum Dots | Core size (nm) | Shell type | Ligand type | OD₄₅₀ | Film thickness (µm) | Total PCE (%) | PWL (nm) | FWHM (nm) |
|---|---|---|---|---|---|---|---|---|
| Thin Shell - 440 nm | 440 | Thin | A | 0.91 | 6.0 | 28.5 | 539 | 33 |
| Thick Shell - 440 nm | 440 | Thick | A | 0.78 | 6.0 | 22.6 | 532 | 34 |
| Thin Shell - 450 nm | 450 | Thin | A | 0.89 | 6.0 | 29.3 | 543 | 34 |
| Thin Shell - 450 nm | 450 | Thin | B | 0.80 | 6.0 | 30.0 | 543 | 34 |
| Thick Shell - 450 nm | 450 | Thick | A | 0.78 | 6.0 | 24.0 | 538 | 36 |

High PCE values of films prepared using the thin shell quantum dots arise due to the combination of improved OD₄₅₀/mass (a value of 0.33 represents a 37% increase over the absorption efficiency of a thicker shell quantum dot emitting at the same PWL) and high PLQY (values between 93-94% represent a 1-2% increase over thicker shell quantum dots).

While various embodiments have been described above, it should be understood that they have been presented by way of example only, and not limitation. It will be apparent to persons skilled in the relevant art that various changes in form and detail can be made therein without departing from the scope of the invention. Thus, the breadth and scope should not be limited by any of the above-described exemplary embodiments, but should be defined only in accordance with the following claims.

## Claims

1. A nanostructure comprising a nanocrystal core, the nanocrystal core comprising InP, a first thin shell and a second thin shell, wherein the first thin shell comprises ZnSe and has a thickness between about 0.25 nm and about 0.8 nm, and wherein the second thin shell comprises ZnS and has a thickness between about 0.09 nm and about 0.3 nm, and wherein the nanostructure exhibits an optical density at 450 nm on a per mass basis of between about 0.30 cm²/mg and about 0.50 cm²/mg.

2. The nanostructure of claim 1, wherein the nanostructure exhibits an optical density at 450 nm on a per mass basis of between about 0.30 cm²/mg and about 0.40 cm²/mg.

3. The nanostructure of claim 1 or 2, wherein the nanostructure exhibits a photoluminescence quantum yield of between about 50% and about 99%.

4. A method of making the nanostructure of any one of claims 1-3, comprising:
(a) admixing an InP core and a first shell precursor, wherein the first shell precursor comprises a zinc source;
(b) adding a second shell precursor, wherein the second shell precursor comprises a selenium source;
(c) raising, lowering, or maintaining the temperature to between about 200 °C and about 350 °C; and
(d) adding a third shell precursor, wherein the third shell precursor comprises a sulfur source;
to provide a nanostructure comprising a nanocrystal core, the nanocrystal core comprising InP, a first thin shell and a second thin shell, wherein the first thin shell comprises ZnSe and has a thickness between about 0.25 nm and about 0.8 nm, and wherein the second thin shell comprises ZnS and has a thickness between about 0.09 nm and about 0.3 nm.

5. The method of claim 4, wherein the temperature is raised, lowered, or maintained in (c) to a temperature between about 280 °C and about 310 °C.

6. The method of claim 4 or 5, further comprising isolating the nanostructure.

7. A nanostructure composition, comprising:
(a) at least one population of nanostructures, the nanostructures comprising a nanocrystal core, the nanocrystal core comprising InP, a first thin shell and a second thin shell, wherein the first thin shell comprises ZnSe and has a thickness between about 0.25 nm and about 0.8 nm, and wherein the second thin shell comprises ZnS and has a thickness between about 0.09 nm and about 0.3 nm, and wherein the nanostructure exhibits an optical density at 450 nm on a per mass basis of between about 0.30 cm²/mg and about 0.50 cm²/mg; and
(b) at least one organic resin.

8. The nanostructure composition of claim 7, wherein the nanostructure exhibits an optical density at 450 nm on a per mass basis of between about 0.30 cm²/mg and about 0.40 cm²/mg.

9. The nanostructure composition of claim 7 or 8, wherein the nanostructure exhibits a photoluminescence quantum yield of between about 50% and about 99%.

10. The nanostructure composition of any one of claims 7-9, wherein the at least one organic resin is a thermosetting resin or a UV curable resin.

11. A nanostructure film layer comprising:
(a) at least one population of nanostructures, the nanostructures comprising a nanocrystal core, the nanocrystal core comprising InP, a first thin shell and a second thin shell, wherein the first thin shell comprises ZnSe and has a thickness between about 0.25 nm and about 0.8 nm, and wherein the second thin shell comprises ZnS and has a thickness between about 0.09 nm and about 0.3 nm; and
(b) at least one organic resin;
wherein the nanostructure film layer exhibits a photoconversion efficiency of between about 25% and about 40%, wherein photoconversion efficiency is measured as a ratio of green photons emitted (forward cast) versus total incident blue photons.

12. The nanostructure film layer of claim 11, wherein the nanostructure film layer exhibits a photoconversion efficiency of between about 28% and about 35%, wherein photoconversion efficiency is measured as a ratio of green photons emitted (forward cast) versus total incident blue photons.

13. The nanostructure film layer of claim 11 or 12, wherein the nanostructure film layer exhibits optical density at 450 nm of between about 0.80 and 0.95.

14. The nanostructure film layer of any one of claims 11-13, wherein the at least one organic resin is a thermosetting resin or a UV curable resin.

15. The nanostructure film layer of any one of claims 11-14, wherein the nanostructure film layer is a color conversion layer in a display device.

## Patentansprüche

1. Nanostruktur mit einem Nanokristallkern, wobei der Nanokristallkern InP umfasst, einer ersten dünnen Schale und einer zweiten dünnen Schale, wobei die erste dünne Schale ZnSe umfasst und eine Dicke zwischen ungefähr 0,25 nm und ungefähr 0,8 nm aufweist, und wobei die zweite dünne Schale ZnS umfasst und eine Dicke zwischen ungefähr 0,09 nm und ungefähr 0,3 nm aufweist, und wobei die Nanostruktur eine massebezogene optische Dichte bei 450 nm zwischen ungefähr 0,30 cm²/mg und ungefähr 0,50 cm²/mg aufweist.

2. Nanostruktur nach Anspruch 1, wobei die Nanostruktur eine massebezogene optische Dichte bei 450 nm zwischen ungefähr 0,30 cm²/mg und ungefähr 0,40 cm²/mg aufweist.

3. Nanostruktur nach Anspruch 1 oder 2, wobei die Nanostruktur eine Photolumineszenzquantenausbeute zwischen ungefähr 50 % und ungefähr 99 % aufweist.

4. Verfahren zum Herstellen der Nanostruktur nach einem der Ansprüche 1 bis 3, das umfasst:
(a) Vermengen eines InP-Kerns und eines ersten Schalenvorläufers, wobei der erste Schalenvorläufer eine Zinkquelle umfasst;
(b) Hinzufügen eines zweiten Schalenvorläufers, wobei der zweite Schalenvorläufer eine Selenquelle umfasst;
(c) Erhöhen, Senken oder Halten der Temperatur auf zwischen ungefähr 200 °C und ungefähr 350 °C; und
(d) Hinzufügen eines dritten Schalenvorläufers, wobei der dritte Schalenvorläufer eine Schwefelquelle umfasst;
um eine Nanostruktur mit einem Nanokristallkern, wobei der Nanokristallkern InP umfasst, einer ersten dünnen Schale und einer zweiten dünnen Schale bereitzustellen, wobei die erste dünne Schale ZnSe umfasst und eine Dicke zwischen ungefähr 0,25 nm und ungefähr 0,8 nm aufweist, und wobei die zweite dünne Schale ZnS umfasst und eine Dicke zwischen ungefähr 0,09 nm und ungefähr 0,3 nm aufweist.

5. Verfahren nach Anspruch 4, wobei die Temperatur in Schritt (c) auf eine Temperatur zwischen ungefähr 280 °C und ungefähr 310 °C erhöht, gesenkt oder darauf gehalten wird.

6. Verfahren nach Anspruch 4 oder 5, das ferner das Isolieren der Nanostruktur umfasst.

7. Nanostrukturzusammensetzung, die umfasst:
(a) zumindest eine Population von Nanostrukturen, wobei die Nanostrukturen einen Nanokristallkern, wobei der Nanokristallkern InP umfasst, eine erste dünne Schale und eine zweite dünne Schale umfassen, wobei die erste dünne Schale ZnSe umfasst und eine Dicke zwischen ungefähr 0,25 nm und ungefähr 0,8 nm aufweist, und wobei die zweite dünne Schale ZnS umfasst und eine Dicke zwischen ungefähr 0,09 nm und ungefähr 0,3 nm aufweist, und wobei die Nanostruktur eine massebezogene optische Dichte bei 450 nm zwischen ungefähr 0,30 cm²/mg und ungefähr 0,50 cm²/mg aufweist; und
(b) zumindest ein organisches Harz.

8. Nanostrukturzusammensetzung nach Anspruch 7, wobei die Nanostruktur eine massebezogene optische Dichte bei 450 nm zwischen ungefähr 0,30 cm²/mg und ungefähr 0,40 cm²/mg aufweist.

9. Nanostrukturzusammensetzung nach Anspruch 7 oder 8, wobei die Nanostruktur eine Photolumineszenzquantenausbeute zwischen ungefähr 50 % und ungefähr 99 % aufweist.

10. Nanostrukturzusammensetzung nach einem der Ansprüche 7 bis 9, wobei das zumindest eine organische Harz ein wärmehärtendes Harz oder ein UV-härtbares Harz ist.

11. Nanostrukturfilmschicht, die umfasst:
(a) zumindest eine Population von Nanostrukturen, wobei die Nanostrukturen einen Nanokristallkern, wobei der Nanokristallkern InP umfasst, eine erste dünne Schale und eine zweite dünne Schale umfassen, wobei die erste dünne Schale ZnSe umfasst und eine Dicke zwischen ungefähr 0,25 nm und ungefähr 0,8 nm aufweist, und wobei die zweite dünne Schale ZnS umfasst und eine Dicke zwischen ungefähr 0,09 nm und ungefähr 0,3 nm aufweist, und
(b) zumindest ein organisches Harz;
wobei die Nanostrukturfilmschicht eine Photoumwandlungseffizienz zwischen ungefähr 25 % und ungefähr 40 % aufweist, wobei die Photoumwandlungseffizienz als Verhältnis von emittierten grünen Photonen (Forward Cast) zu den gesamten einfallenden blauen Photonen gemessen wird.

12. Nanostrukturfilmschicht nach Anspruch 11, wobei die Nanostrukturfilmschicht eine Photoumwandlungseffizienz zwischen ungefähr 28 % und ungefähr 35 % aufweist, wobei die Photoumwandlungseffizienz als Verhältnis von emittierten grünen Photonen (Forward Cast) zu den gesamten einfallenden blauen Photonen gemessen wird.

13. Nanostrukturfilmschicht nach Anspruch 11 oder 12, wobei die Nanostrukturfilmschicht eine optische Dichte bei 450 nm zwischen ungefähr 0,80 und 0,95 aufweist.

14. Nanostrukturfilmschicht nach einem der Ansprüche 11 bis 13, wobei das zumindest eine organische Harz ein wärmehärtendes Harz oder ein UV-härtbares Harz ist.

15. Nanostrukturfilmschicht nach einem der Ansprüche 11 bis 14, wobei die Nanostrukturfilmschicht eine Farbumwandlungsschicht in einer Anzeigevorrichtung ist.

## Revendications

1. Nanostructure comprenant un coeur nanocristallin, le coeur nanocristallin comprenant de l'InP, une première enveloppe mince et une deuxième enveloppe mince, dans laquelle la première enveloppe mince comprend du ZnSe et a une épaisseur entre environ 0,25 nm et environ 0,8 nm, et dans laquelle la deuxième enveloppe mince comprend du ZnS et a une épaisseur entre environ 0,09 nm et environ 0,3 nm, et dans laquelle la nanostructure présente une densité optique à 450 nm sur une base par masse entre environ 0,30 cm²/mg et environ 0,50 cm²/mg.

2. Nanostructure selon la revendication 1, dans laquelle la nanostructure présente une densité optique à 450 nm sur une base par masse entre environ 0,30 cm²/mg et environ 0,40 cm²/mg.

3. Nanostructure selon la revendication 1 ou 2, dans laquelle la nanostructure présente un rendement quantique de photoluminescence entre environ 50 % et environ 99 %.

4. Procédé de préparation de la nanostructure selon l'une quelconque des revendications 1 à 3, comprenant :
(a) le mélange d'un coeur d'InP et d'un premier précurseur d'enveloppe, dans lequel le premier précurseur d'enveloppe comprend une source de zinc ;
(b) l'ajout d'un deuxième précurseur d'enveloppe, dans lequel le deuxième précurseur d'enveloppe comprend une source de sélénium ;
(c) l'élévation, l'abaissement ou le maintien de la température entre environ 200 °C et environ 350 °C ; et
(d) l'ajout d'un troisième précurseur d'enveloppe, dans lequel le troisième précurseur d'enveloppe comprend une source de soufre ;
pour fournir une nanostructure comprenant un coeur nanocristallin, le coeur nanocristallin comprenant de l'InP, une première enveloppe mince et une deuxième enveloppe mince, dans lequel la première enveloppe mince comprend du ZnSe et a une épaisseur entre environ 0,25 nm et environ 0,8 nm, et dans lequel la deuxième enveloppe mince comprend du ZnS et a une épaisseur entre environ 0,09 nm et environ 0,3 nm.

5. Procédé selon la revendication 4, dans lequel la température est élevée, abaissée ou maintenue dans (c) à une température entre environ 280 °C et environ 310 °C.

6. Procédé selon la revendication 4 ou 5, comprenant en outre l'isolement de la nanostructure.

7. Composition de nanostructure, comprenant :
(a) au moins une population de nanostructures, les nanostructures comprenant un coeur nanocristallin, le coeur nanocristallin comprenant de l'InP, une première enveloppe mince et une deuxième enveloppe mince, dans laquelle la première enveloppe mince comprend du ZnSe et a une épaisseur entre environ 0,25 nm et environ 0,8 nm, et dans laquelle la deuxième enveloppe mince comprend du ZnS et a une épaisseur entre environ 0,09 nm et environ 0,3 nm, et dans laquelle la nanostructure présente une densité optique à 450 nm sur une base par masse entre environ 0,30 cm²/mg et environ 0,50 cm²/mg ; et
(b) au moins une résine organique.

8. Composition de nanostructure selon la revendication 7, dans laquelle la nanostructure présente une densité optique à 450 nm sur une base par masse entre environ 0,30 cm²/mg et environ 0,40 cm²/mg.

9. Composition de nanostructure selon la revendication 7 ou 8, dans laquelle la nanostructure présente un rendement quantique de photoluminescence entre environ 50 % et environ 99 %.

10. Composition de nanostructure selon l'une quelconque des revendications 7 à 9, dans laquelle l'au moins une résine organique est une résine thermodurcissable ou une résine durcissable aux UV.

11. Couche de film à nanostructure comprenant :
(a) au moins une population de nanostructures, les nanostructures comprenant un coeur nanocristallin, le coeur nanocristallin comprenant de l'InP, une première enveloppe mince et une deuxième enveloppe mince, dans laquelle la première enveloppe mince comprend du ZnSe et a une épaisseur entre environ 0,25 nm et environ 0,8 nm, et dans laquelle la deuxième enveloppe mince comprend du ZnS et a une épaisseur entre environ 0,09 nm et environ 0,3 nm ; et
(b) au moins une résine organique ;
dans laquelle la couche de film à nanostructure présente une efficacité de photoconversion entre environ 25 % et environ 40 %, dans laquelle l'efficacité de photoconversion est mesurée en tant que rapport de photons verts émis (projection vers l'avant) par rapport aux photons bleus incidents totaux.

12. Couche de film à nanostructure selon la revendication 11, dans laquelle la couche de film à nanostructure présente une efficacité de photoconversion entre environ 28 % et environ 35 %, dans laquelle l'efficacité de photoconversion est mesurée en tant que rapport de photons verts émis (projection vers l'avant) par rapport aux photons bleus incidents totaux.

13. Couche de film à nanostructure selon la revendication 11 ou 12, dans laquelle la couche de film à nanostructure présente une densité optique à 450 nm entre environ 0,80 et 0,95.

14. Couche de film à nanostructure selon l'une quelconque des revendications 11 à 13, dans laquelle l'au moins une résine organique est une résine thermodurcissable ou une résine durcissable aux UV.

15. Couche de film à nanostructure selon l'une quelconque des revendications 11 à 14, dans laquelle la couche de film à nanostructure est une couche de conversion de couleur dans un dispositif d'affichage.
